# EUROPEAN PATENT APPLICATION

(11) **EP 4 844 487 A1**
(43) Date of publication of application: **25.11.2026**
(21) Application number: 26179439.0
(22) Date of filing: 19.05.2026
(51) Int. Cl.: G03F 7/09

(54) **RESIST UNDERLAYER FILM MATERIAL, PATTERNING PROCESS, AND METHOD FOR FORMING RESIST UNDERLAYER FILM**

(30) Priority: 22.05.2025 JP 2025085947
(71) Applicant: SHIN-ETSU CHEMICAL CO., LTD., Tokyo 100-0005 (JP)
(72) Inventor: Niida, Keisuke, Niigata (JP); Nakahara, Takayoshi, Niigata (JP)
(74) Representative: Schicker, Silvia

(57) **Abstract**

The present invention is a resist underlayer film material, containing: (A) a compound or resin represented by the following general formula (1); and (B) an organic solvent, where each Y has either a terminal group structure represented by the following general formula (2) or a terminal group structure represented by the following general formula (3), "a" and "b" satisfying relationships a+b = 1.0, 0.70 ≤ a ≤ 0.99, and 0.01 ≤ b ≤ 0.30, where the "a" and the "b" respectively represent a proportion of the terminal group structure represented by the following general formula (2) constituting the Y and a proportion of the terminal group structure represented by the following general formula (3) constituting the Y, and "n" represents an integer of 1 to 10. This can provide a resist underlayer film material that makes it possible to form a resist underlayer film excellent in flatness and film-formability even on a substrate to be processed having portions that are particularly difficult to planarize and that can also give a resist underlayer film having appropriate etching properties.

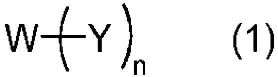

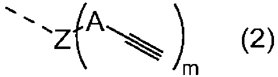

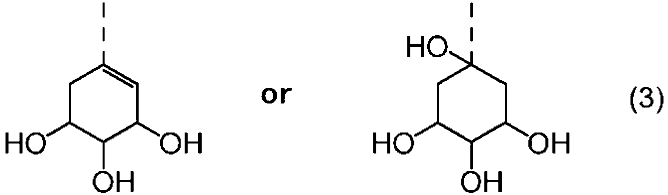

## Description

### TECHNICAL FIELD

The present invention relates to: a resist underlayer film material usable for fine patterning by a multilayer resist method in a semiconductor device manufacturing process; a patterning process using the material; and a method for forming a resist underlayer film.

### BACKGROUND ART

As LSI advances toward high integration and high processing speed, miniaturization of pattern size is progressing rapidly. Along with the miniaturization, lithography technology has achieved a fine patterning by shortening the wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, there arises a problem that when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. There has been a problem that the resist film is thus damaged and collapses during processing of the substrate, and the resist pattern cannot be precisely transferred to the substrate to be processed. Accordingly, higher dry etching resistance has been required in a resist composition along with the miniaturization of the pattern. However, on the other hand, resins used for photoresist compositions have been required to have low absorbance at the wavelength to be used for the exposure in order to achieve a higher resolution. Accordingly, as the exposure light shifts from i-beam to KrF and to ArF to have a shorter wavelength, the resin also shifts to novolak resins, polyhydroxystyrene, and resins having an aliphatic polycyclic skeleton. This shift actually accelerates an etching rate under the dry etching conditions during substrate processing, and recent photoresist compositions having high resolution tend to have low etching resistance.

As a result, a substrate to be processed has to be dry-etched with a thinner photoresist film having lower etching resistance. It is important to provide a material for this process and the process itself.

A multilayer resist method is one solution for these problems. This method is as follows: a middle layer film having a different etching selectivity from a photoresist film (i.e., a resist upper layer film) is placed between the resist upper layer film and a substrate to be processed; a pattern is formed in the resist upper layer film; then, the pattern is transferred to the middle layer film by dry etching while using the resist upper layer film pattern as a dry etching mask; and the pattern is further transferred to the substrate to be processed by dry etching while using the middle layer film as a dry etching mask.

One of the multilayer resist methods is a 3-layer resist method, which can be performed with a typical resist composition used in the monolayer resist method. For example, this 3-layer resist method includes the following steps: an organic film containing a novolak resin or the like is formed as a resist underlayer film on a substrate to be processed; a silicon-containing film is formed thereon as a resist middle layer film; and a usual organic photoresist film is formed thereon as a resist upper layer film. Since the organic resist upper layer film exhibits a favorable etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. According to this process, even when using a resist composition which is difficult to form a pattern in so that the pattern has a sufficient film thickness for directly processing the substrate to be processed or a resist composition which does not have sufficient dry etching resistance for processing the substrate, a pattern can be transferred to a silicon-containing film (resist middle layer film). In addition, by subsequently transferring the pattern by dry etching using an oxygen- or hydrogen-based gas plasma, it is possible to obtain a pattern of an organic film (resist underlayer film) containing a novolak resin or the like having a sufficient dry etching resistance for processing the substrate. As such a resist underlayer film, many are already known, such as those disclosed in Patent Document 1, for example.

In recent years, consideration of the production of semiconductor devices having a new structure such as a multigate structure has become active. In response, demands are rising for a resist underlayer film having better flatness and filling property than before. For example, when an underlying substrate to be processed has a fine pattern structure, such as a hole, a trench, or a fin, it is necessary to have filling (gap-filling) property for filling in the pattern with a film without any voids by using a resist underlayer film. In addition, when the underlying substrate to be processed has a step(s), or when a pattern-dense region and a pattern-free region exist on the same wafer, it is necessary to planarize the film surface with the resist underlayer film. By virtue of planarizing the surface of the underlayer film, fluctuation in the film thickness of a resist middle layer film or a resist upper layer film formed thereon can be controlled, whereby a focus margin in lithography or a margin in the subsequent processing step of the substrate to be processed can be suppressed from decreasing.

Moreover, the organic film material excellent in filling property and flatness is not limited to the underlayer film for a multilayer resist, and is also widely usable as a planarizing material for manufacturing a semiconductor device, e.g., for planarizing a substrate prior to patterning by nanoimprinting. Furthermore, for global planarizing in the semiconductor device manufacturing process, a CMP process is now generally used. However, the CMP process is costly, so that this material is also expected to be used for the global planarizing method, instead of CMP.

For forming a flat film for planarizing an uneven semiconductor substrate, proposed is a resist underlayer film material containing a compound having low viscosity and high thermal flowability (Patent Document 2). However, the material has a problem of considerably decreased ability to wet a hydrophobic substrate treated with, for example, hexamethyldisilazane (hereinafter, referred to as HMDS), and being likely to cause a pinhole or film edge recession. Furthermore, in the latest devices, the resist underlayer film has also been thinned due to the thinning of the resist upper layer film that accompanies pattern miniaturization, and therefore, it is more difficult to guarantee wettability. To improve the wettability of an underlayer film material, it is effective to improve the adhesion to the substrate, and proposed is a resist underlayer film material containing, as a component, an amide structure as a polar functional group (Patent Document 3). However, although having both wettability on a silicon substrate and flatness, the resist underlayer film material has an insufficient ability to wet a hydrophobic substrate. Thus, there are demands for: an underlayer film material having both excellent flatness and ability to wet a hydrophobic substrate and sufficient etching resistance; and a patterning process using the material.

In addition, the structures of substrates to be processed are becoming complex as described above. Furthermore, for the surface of a substrate to be processed, the following materials are also being examined: novel materials having high electron mobility using strained silicon, gallium arsenic, and so forth; ultrathin polysilicon controlled in units of angstrom; and the like. Thus, films are expected to be formed on surfaces of substrates to be processed having various shapes and qualities. Therefore, in order to ensure a process margin, not only excellent flatness, but also being able to form a film without dependence on the quality or shape of the substrate to be processed is an important feature.

### CITATION LIST

### PATENT LITERATURE

Patent Document 1: JP2004-205685A
Patent Document 2: JP2017-119670A
Patent Document 3: JP2021-196467A

### SUMMARY OF INVENTION

### TECHNICAL PROBLEM

The present invention has been made in view of the above circumstances. An object of the present invention is to provide: a resist underlayer film material that makes it possible to form a resist underlayer film excellent in flatness and film-formability even on a substrate to be processed having portions that are particularly difficult to planarize, such as a wide trench structure, the resist underlayer film also having appropriate etching properties, in a fine patterning process according to a multilayer resist method in a semiconductor device manufacturing process; a patterning process using the material; and a method for forming a resist underlayer film by using the material.

### SOLUTION TO PROBLEM

To achieve the object, the present invention provides a resist underlayer film material, comprising:
(A) a compound or resin represented by the following general formula (1); and
(B) an organic solvent, 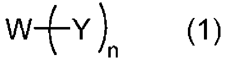
   wherein W represents an n-valent organic group having 2 to 50 carbon atoms, each Y has either a terminal group structure represented by the following general formula (2) or a terminal group structure represented by the following general formula (3), "a" and "b" satisfying relationships a+b = 1.0, 0.70 ≤ a ≤ 0.99, and 0.01 ≤ b ≤ 0.30, where the "a" and the "b" respectively represent a proportion of the terminal group structure represented by the following general formula (2) constituting the Y and a proportion of the terminal group structure represented by the following general formula (3) constituting the Y, and "n" represents an integer of 1 to 10, 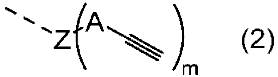
   wherein a broken line represents an attachment point, Z represents an (m+1)-valent aromatic group having 6 to 20 carbon atoms, A represents a single bond or -O-(CH₂)ₚ-, "m" represents an integer of 1 to 5, and "p" represents an integer of 1 to 10, 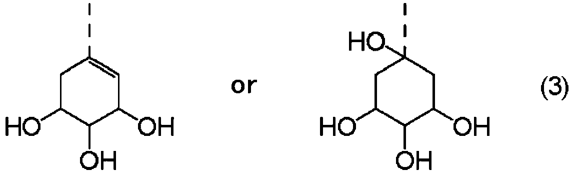
   wherein a broken line represents an attachment point.

Such a resist underlayer film material makes it possible to form a resist underlayer film excellent in flatness and film-formability even on a substrate to be processed having portions that are particularly difficult to planarize, such as a wide trench structure, in a fine patterning process according to a multilayer resist method, the underlayer film also being capable of exhibiting appropriate etching properties, the resist underlayer film being excellent in film-formability on a hydrophobic substrate treated with HMDS, for example. Furthermore, a resist underlayer film material in which the proportions "a" and "b" satisfy the above-described relationships makes it possible to form a resist underlayer film having both flatness and film-formability with an appropriate balance. In particular, by introducing a terminal group structure having the structure represented by the general formula (2), it is possible to achieve both thermal flowability and heat resistance, which are conflicting properties. Furthermore, by introducing a terminal group structure having the structure represented by the general formula (3), adhesiveness to a substrate can be imparted, and it is possible to achieve a greater effect of improving film-formability. In particular, the material is effective for suppressing recession of a film edge.

The A in the general formula (2) preferably represents -OCH₂-.

In such a resist underlayer film material, film shrinkage (contraction) due to thermosetting can be suppressed, and it is possible to form a resist underlayer film having better flatness.

Furthermore, the general formula (2) is preferably any of the following general formulae (4), (5), and (6), 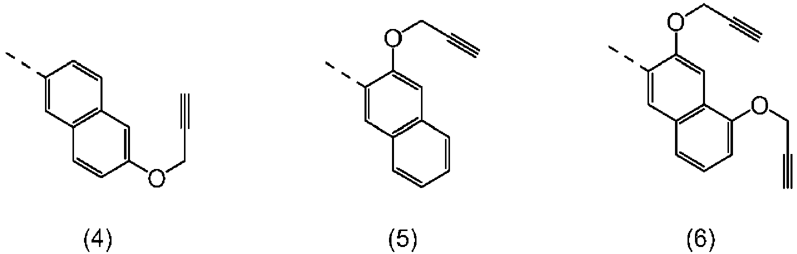 wherein a broken line represents an attachment point.

To such a resist underlayer film material, it is possible further to impart not only an effect of improving flatness by suppressing shrinkage, but also various properties, such as heat resistance and etching resistance, and it is possible to form a resist underlayer film having a better process margin.

The W in the general formula (1) is preferably represented by the following general formula (7), 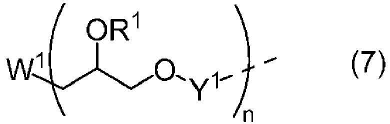 wherein a broken line represents an attachment point, R¹ represents a hydrogen atom or an alkyl group or an acyl group each having 1 to 20 carbon atoms, the alkyl group or the acyl group optionally containing an oxygen atom and/or a nitrogen atom, W¹ represents an n-valent organic group having 1 to 47 carbon atoms, Y¹ represents a single bond or a carbonyl group, and "n" represents an integer of 1 to 10.

When the W in the general formula (1) has a partial structure represented by the general formula (7), better thermal flowability can be imparted to the inventive resist underlayer film material, and therefore, better flatness can be imparted.

In this case, it is more preferable that the W¹ in the general formula (7) has a structure represented by any of the following formulae.

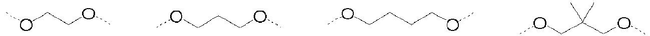

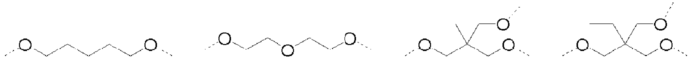

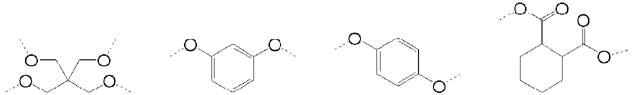

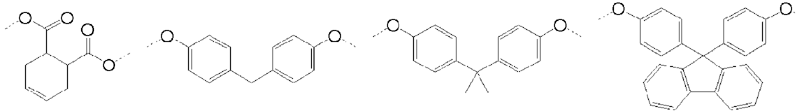

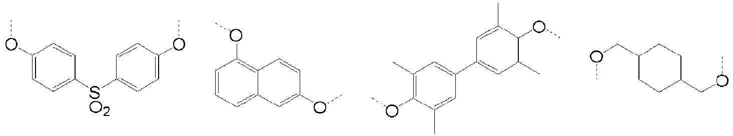

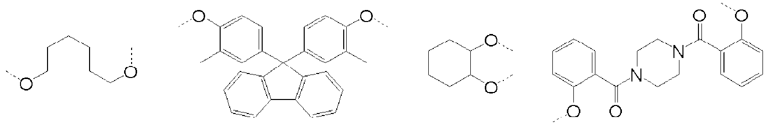

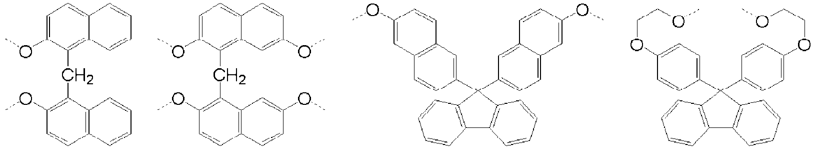

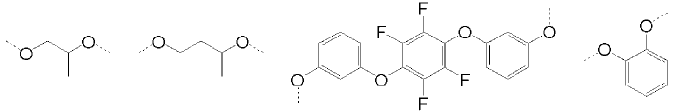

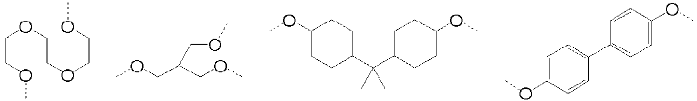

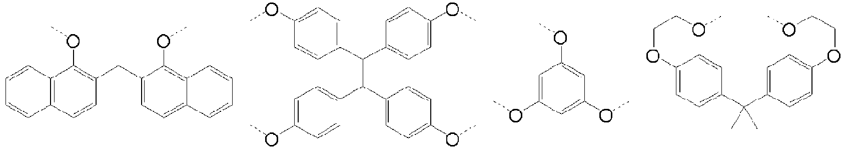

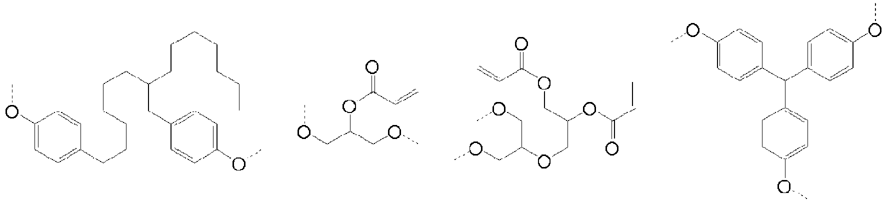

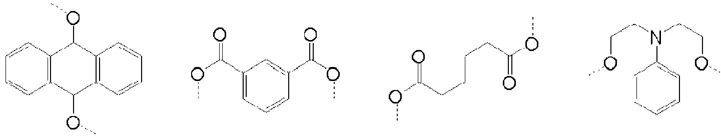

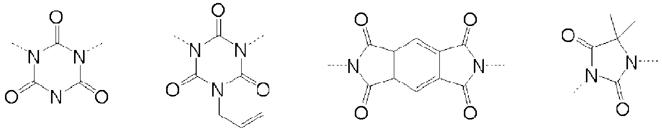

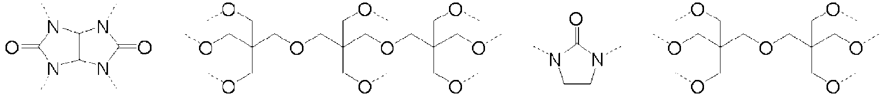

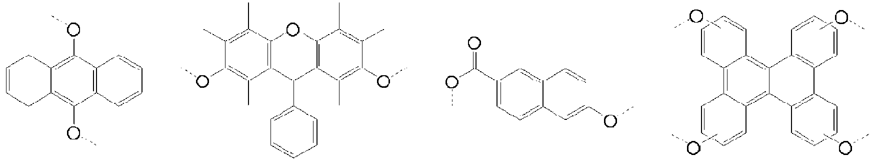

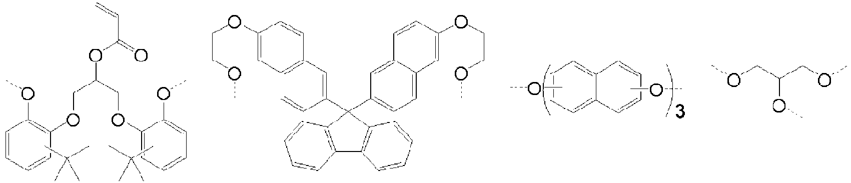

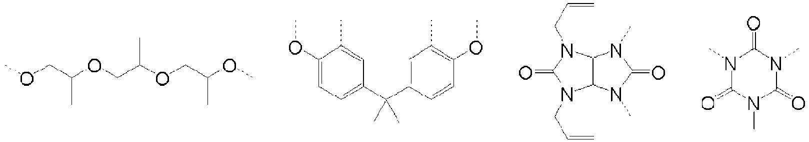

In the formulae, a broken line represents an attachment point.

Such a resist underlayer film material makes it possible to form a resist underlayer film having better film-formability and better flatness, and can be manufactured particularly easily.

The compound or resin (A) preferably has a weight-average molecular weight of 3,000 or less in terms of polystyrene.

Such a resist underlayer film material has low viscosity and high thermal flowability, and therefore, is excellent in flatness, the resist underlayer film also having both such excellent flatness and film-formability on a hydrophobic substrate.

The organic solvent (B) is preferably a mixture of one or more kinds of organic solvent having a boiling point of lower than 180°C and one or more kinds of organic solvent having a boiling point of 180°C or higher.

Such a resist underlayer film material makes it possible to achieve better flatness of a formed resist underlayer film regardless of the design, such as pattern density, of the substrate to be processed.

The inventive resist underlayer film material can further comprise one or more kinds selected from the group consisting of:
(C) a base generator;
(D) a surfactant;
(E) a crosslinking agent;
(F) a plasticizer; and
(G) a colorant.

As described, the inventive resist underlayer film material can contain a base generator (C) for suppressing recession of a film edge, can contain a surfactant (D) for improving coatability in spin-coating, can contain a crosslinking agent (E) for further promoting a crosslinking curing reaction, can contain a plasticizer (F) for further improving filling property and/or flatness, and can contain a colorant (G) for adjusting absorption property. By virtue of the presence or absence and choice of these additives, it is possible to make fine adjustments to performance, such as film-formability, curability, filling property, and optical characteristics, according to requirements, and this is preferable in terms of practical use.

Furthermore, the base generator (C) is preferably a compound that exhibits basicity upon pyrolysis.

It can be expected that, in such a resist underlayer film material, the three adjacent hydroxy groups in the component (A) exhibit ionicity when the film is baked, thereby, interaction with the substrate is increased, and therefore, the material can exhibit better film-formability. By adjusting the amount to be contained, it is possible to achieve both excellent thermal flowability and suitable interaction with the substrate.

The base generator (C) is preferably a compound represented by any of the following general formulae (8), (9), and (10), 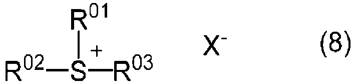 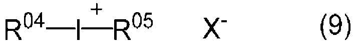 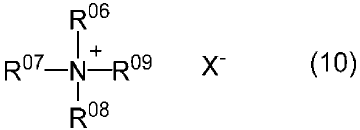 wherein R⁰¹ to R⁰³ each independently represent a linear, branched, or cyclic alkyl group or alkenyl group, each having 1 to 10 carbon atoms, optionally having a substituent which is a heteroatom and optionally having an intervening heteroatom, or represent an aryl group or aralkyl group each having 6 to 18 carbon atoms, optionally having a substituent which is a heteroatom, and optionally having an intervening heteroatom, any two of R⁰¹, R⁰², and R⁰³ optionally being bonded to each other to form a ring together with the sulfur atom in the formula, X⁻ represents an organic or inorganic anion to be a counter ion, provided that X⁻ does not include OH⁻, R⁰⁴ and R⁰⁵ each independently represent an aryl group having 6 to 20 carbon atoms, part or all of hydrogen atoms of the aryl group optionally being substituted with a linear, branched, or cyclic alkyl group or alkoxy group each having 1 to 10 carbon atoms, and R⁰⁴ and R⁰⁵ optionally being bonded to each other to form a ring together with the iodine atom in the formula, and R⁰⁶, R⁰⁷, R⁰⁸, and R⁰⁹ each independently represent a hydrogen atom, represent a linear, branched, or cyclic alkyl group or alkenyl group each having 1 to 20 carbon atoms, and optionally having a substituent which is a heteroatom and optionally having an intervening heteroatom, or represent an aryl group or aralkyl group each having 6 to 18 carbon atoms, optionally having a substituent which is a heteroatom, and optionally having an intervening heteroatom, any two of R⁰⁶, R⁰⁷, R⁰⁸, and R⁰⁹ optionally being bonded to each other to form a ring together with the nitrogen atom in the formula.

It is more preferable that the anion X⁻ in the general formulae (8), (9), and (10) is an anion selected from the group consisting of ions having structures represented by any of the following general formulae (11), (12), and (13), a chloride ion, a bromide ion, an iodide ion, a fluoride ion, a cyanide ion, a nitrate ion, and a nitrite ion,

**R¹⁰-COO⁻** **(11)**

**R¹¹-SO₃⁻** **(12)**

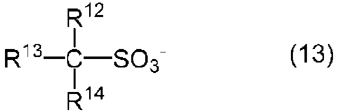

wherein R¹⁰ represents a linear, branched, or cyclic alkyl group, an alkenyl group, an aralkyl group, or an aryl group, each having 1 to 20 carbon atoms and optionally containing an ether group, an ester group, or a carbonyl group, one or more hydrogen atoms of the groups optionally being substituted with a halogen atom, a hydroxy group, a carboxy group, an amino group, and/or a cyano group, R¹¹ represents an aryl group having 6 to 20 carbon atoms, one or more hydrogen atoms of the aryl group optionally being substituted with a halogen atom, a hydroxy group, a carboxy group, an amino group, and/or a cyano group, and R¹², R¹³, and R¹⁴ each independently represent a hydrogen atom, a halogen atom other than a fluorine atom, or a linear, branched, or cyclic alkyl group, alkenyl group, an aralkyl group, or an aryl group, each having 1 to 20 carbon atoms and optionally containing an ether group, an ester group, or a carbonyl group, one or more hydrogen atoms of the groups optionally being substituted with a halogen atom, a hydroxy group, a carboxy group, an amino group, and/or a cyano group, and two or more of R¹², R¹³, and R¹⁴ optionally being bonded to each other to form a ring.

It is further preferable that a conjugate acid X-H of the X⁻ in the general formulae (8), (9), and (10) has a boiling point of 200°C or lower.

By appropriately selecting such a base generator that exhibits basicity upon pyrolysis (thermal base generator), basicity can be exhibited in accordance with the baking temperature of the resist underlayer film material, and both film-formability and flatness can be achieved more certainly. Furthermore, the entire quantity is decomposed or evaporates during baking and does not remain in the film after baking, and therefore, there is no risk of adversely affecting properties other than film-formability. Note that, in the present description, the boiling point is the value at 1 atmosphere (1013 hPa).

The crosslinking agent (E) is preferably a compound represented by the following general formula (14), 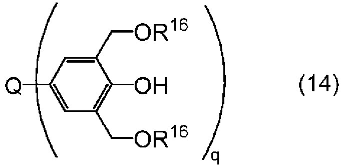 wherein Q represents a single bond or a q-valent hydrocarbon group having 1 to 20 carbon atoms, R¹⁶ represents a hydrogen atom or an alkyl group having 1 to 20 carbon atoms, and "q" represents an integer of 1 to 5.

When the crosslinking agent is as described, a crosslinking reaction progresses even when an acid generator is not contained, and therefore, it is possible to improve curability without degradation of the effect of the base generator of improving film-formability. Furthermore, the crosslinking agent represented by the general formula (14) contains a phenolic hydroxy group, and therefore, a higher effect of improving film-formability can be expected by virtue of the action of the base generator.

The present invention also provides a patterning process for forming a pattern in a substrate to be processed, comprising the steps of:
(I-1) applying the inventive resist underlayer film material onto a substrate to be processed to obtain a coating film and then heating the coating film to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(I-4) transferring the pattern to the resist underlayer film by dry-etching the resist underlayer film while using the resist upper layer film having the formed pattern as a mask; and
(I-5) forming the pattern in the substrate to be processed by processing the substrate to be processed while using the resist underlayer film having the formed pattern as a mask.

The present invention also provides a patterning process for forming a pattern in a substrate to be processed, comprising the steps of:
(II-1) applying the inventive resist underlayer film material onto a substrate to be processed to obtain a coating film and then heating the coating film to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry-etching the resist middle layer film while using the resist upper layer film having the formed pattern as a mask;
(II-6) transferring the pattern to the resist underlayer film by dry-etching the resist underlayer film while using the resist middle layer film having the transferred pattern as a mask; and
(II-7) forming the pattern in the substrate to be processed by processing the substrate to be processed while using the resist underlayer film having the formed pattern as a mask.

The present invention also provides a patterning process for forming a pattern in a substrate to be processed, comprising the steps of:
(III-1) applying the inventive resist underlayer film material onto a substrate to be processed to obtain a coating film and then heating the coating film to form a resist underlayer film;
(III-2) forming an inorganic hard mask middle layer film selected from the group consisting of a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry-etching the organic thin film and the inorganic hard mask middle layer film while using the resist upper layer film having the formed pattern as a mask;
(III-7) transferring the pattern to the resist underlayer film by dry-etching the resist underlayer film while using the inorganic hard mask middle layer film having the transferred pattern as a mask; and
(III-8) forming the pattern in the substrate to be processed by processing the substrate to be processed while using the resist underlayer film having the formed pattern as a mask.

As described, the inventive resist underlayer film material can be used suitably for various patterning processes such as: a 2-layer resist process; a 3-layer resist process using a resist middle layer film; and a 4-layer resist process using an organic thin film in addition to these. These patterning processes can effectively alleviate unevenness and/or steps of a substrate to be processed by forming a resist underlayer film, and are suitable for photolithography of a resist upper layer film.

In the inventive patterning process, the inorganic hard mask middle layer film can be formed by a CVD method or an ALD method.

In the inventive patterning process, a combination of an inorganic hard mask middle layer film formed, for example, by a CVD method or an ALD method and a resist underlayer film formed by a spin-coating method is possible.

In the inventive patterning processes, a substrate having a structure or step having a height of 30 nm or more can be used as the substrate to be processed.

Furthermore, in the inventive patterning processes, a substrate having a static contact angle of 50° or more with water can be used as the substrate to be processed.

The inventive resist underlayer film material is excellent in filling property, flatness, and film-formability on a hydrophobic substrate, and therefore, is particularly useful for fine processing of such a substrate having a structure or step.

The present invention also provides a method for forming a resist underlayer film that functions as an organic flat film employed in a semiconductor device manufacturing process, the method comprising:
spin-coating a substrate to be processed with the inventive resist underlayer film material; and
heating the substrate coated with the resist underlayer film material at a temperature of 100°C or higher to 600°C or lower for 10 to 600 seconds to cure the material and form a resist underlayer film.

The present invention also provides a method for forming a resist underlayer film that functions as an organic flat film employed in a semiconductor device manufacturing process, the method comprising:
spin-coating a substrate to be processed with the inventive resist underlayer film material; and
heating the substrate coated with the resist underlayer film material in an atmosphere having an oxygen concentration of 1 volume% or more to 21 volume% or less to cure the material and form a resist underlayer film.

According to such methods, the crosslinking reaction during formation of the resist underlayer film can be promoted, so that mixing with the upper layer film can be more highly suppressed. Furthermore, by adjusting the heating temperature, time, and oxygen concentration appropriately within the above-described ranges, it is possible to achieve the filling property, flatness, and curing property of the resist underlayer film suitable for the purpose.

The present invention also provides a method for forming a resist underlayer film that functions as an organic flat film employed in a semiconductor device manufacturing process, the method comprising:
spin-coating a substrate to be processed with the inventive resist underlayer film material; and
heating the substrate coated with the resist underlayer film material in an atmosphere having an oxygen concentration of less than 1 volume% to cure the material and form a resist underlayer film.

According to such a method, even when the substrate to be processed contains a material that is unstable to heating under an oxygen atmosphere, the crosslinking reaction during formation of the resist underlayer film can be promoted without the degradation of the substrate to be processed, and mixing with the upper layer film can be suppressed more highly. Therefore, such a method is useful.

A substrate having a structure or step having a height of 30 nm or more can be used as the substrate to be processed.

Furthermore, a substrate having a static contact angle of 50° or more with water can be used as the substrate to be processed.

The inventive methods for forming a resist underlayer film use the inventive resist underlayer film material, which can form a resist underlayer film excellent in filling property and/or flatness and film-formability on a hydrophobic substrate, and therefore, are particularly suitable for forming a resist underlayer film on such a substrate having a structure or step.

### ADVANTAGEOUS EFFECTS OF INVENTION

As described above, the inventive resist underlayer film material makes it possible to form a resist underlayer film excellent in flatness and film-formability even on a substrate to be processed having portions that are particularly difficult to planarize, such as a wide trench structure, in a fine patterning process according to a multilayer resist method, the underlayer film also being capable of exhibiting appropriate etching properties. Therefore, the inventive resist underlayer film material, the inventive patterning processes, and the inventive methods for forming a resist underlayer film can be used particularly suitably for multilayer resist processes that include the planarization of a substrate to be processed having a step or unevenness, and are extremely useful in fine patterning for manufacturing a semiconductor device. In particular, it is possible to provide a resist underlayer film material, a patterning process using the material, and a method for forming a resist underlayer film by using the material that make it possible to form a resist underlayer film which is excellent in flatness and can be formed without dependence on the substrate even on a substrate to be processed having portions that are particularly difficult to planarize, such as a wide trench structure, and furthermore, that can provide appropriate etching properties and optical characteristics in a fine patterning process according to a multilayer resist method in a semiconductor device manufacturing process, even when an acid generator is not contained. In particular, it is possible to suppress pinholes and edge shrinkage (recession) by the three adjacent hydroxy groups in the terminal structure represented by the general formula (3) in the compound or resin (A) exhibiting strong interaction with the substrate surface, even when a resist underlayer film is to be formed on a wafer subjected to a hydrophobization treatment, such as treatment with HMDS.

### BRIEF DESCRIPTION OF DRAWINGS

FIG. 1 is an explanatory diagram of an example of an inventive patterning process according to a 3-layer resist process.
FIG. 2 is an explanatory diagram of a method for evaluating the edge recession in Examples.
FIG. 3 is an explanatory diagram of a method for evaluating the filling property in Examples.
FIG. 4 is an explanatory diagram of a method for evaluating flatness in Examples.

### DESCRIPTION OF EMBODIMENTS

As described above, there have been demands for the development of: a resist underlayer film material that makes it possible to form a resist underlayer film excellent in film-formability and flatness even on a substrate to be processed having portions that are particularly difficult to planarize, such as a wide trench structure, the resist underlayer film further having excellent filling property, appropriate etching characteristics, and appropriate optical characteristics in a fine patterning process according to a multilayer resist method in a semiconductor device manufacturing process; a patterning process using the material; and a method for forming a resist underlayer film by using the material.

The present inventors have investigated various resist underlayer film materials and patterning processes to realize high filling property and/or high flatness by forming an underlayer film and to realize excellent film-formability in multilayer lithography using a resist underlayer film. As a result, the present inventors have found out that a resist underlayer film material mainly containing a compound or resin that contains three adjacent hydroxy groups in some terminal group structures and contains, in other terminal group structures, a moiety that can impart thermal flowability before curing and can also cause a curing reaction via a rigid cyclic structure makes it possible to form a resist underlayer film excellent in flatness and film-formability even on a substrate to be processed having portions that are particularly difficult to planarize, and that the underlayer film can also exhibit appropriate etching properties. Thus, the present invention has been completed.

That is, the present invention provides a resist underlayer film material, comprising:
(A) a compound or resin represented by the following general formula (1); and
(B) an organic solvent, 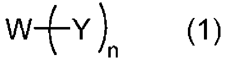
   wherein W represents an n-valent organic group having 2 to 50 carbon atoms, each Y has either a terminal group structure represented by the following general formula (2) or a terminal group structure represented by the following general formula (3), "a" and "b" satisfying relationships a+b = 1.0, 0.70 ≤ a ≤ 0.99, and 0.01 ≤ b ≤ 0.30, where the "a" and the "b" respectively represent a proportion of the terminal group structure represented by the following general formula (2) constituting the Y and a proportion of the terminal group structure represented by the following general formula (3) constituting the Y, and "n" represents an integer of 1 to 10, 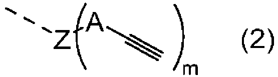
   wherein a broken line represents an attachment point, Z represents an (m+1)-valent aromatic group having 6 to 20 carbon atoms, A represents a single bond or -O-(CH₂)ₚ-, "m" represents an integer of 1 to 5, and "p" represents an integer of 1 to 10, 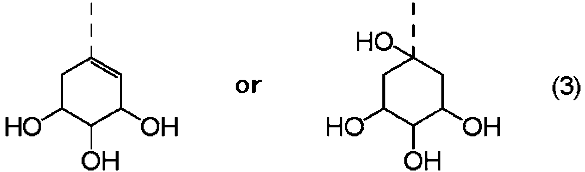
   wherein a broken line represents an attachment point.

Hereinafter, the present invention will be described in detail, but the present invention is not limited thereto.

### <Resist Underlayer Film Material>

The inventive resist underlayer film material can be used, for example, in a multilayer resist method as described above, and
contains (A) a compound or resin represented by the following general formula (1) and (B) an organic solvent.

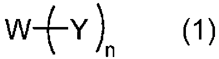

In the formula, W represents an n-valent organic group having 2 to 50 carbon atoms, each Y has either a terminal group structure represented by the following general formula (2) or a terminal group structure represented by the following general formula (3), "a" and "b" satisfying relationships a+b = 1.0, 0.70 ≤ a ≤ 0.99, and 0.01 ≤ b ≤ 0.30, where the "a" and the "b" respectively represent a proportion of the terminal group structure represented by the following general formula (2) constituting the Y and a proportion of the terminal group structure represented by the following general formula (3) constituting the Y, and "n" represents an integer of 1 to 10.

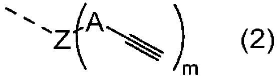

In the formula, a broken line represents an attachment point, Z represents an (m+1)-valent aromatic group having 6 to 20 carbon atoms, A represents a single bond or -O-(CH₂)ₚ-, "m" represents an integer of 1 to 5, and "p" represents an integer of 1 to 10.

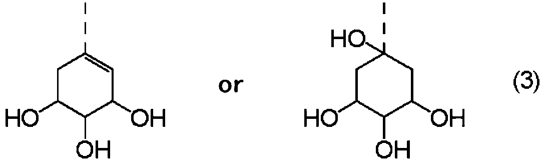

In the formulae, a broken line represents an attachment point.

The inventive resist underlayer film material mainly contains (A) a compound or resin represented by the general formula (1) (hereinafter, also referred to as "a compound or resin (A) containing three adjacent hydroxy groups in some terminal group structures" or a component (A)), and this component (A) includes structures (terminal group structures represented by the general formula (3)) having three adjacent hydroxy groups as some terminal group structures and includes, in other terminal group structures, moieties (terminal group structures represented by the general formula (2)) that can impart thermal flowability and can also cause a curing reaction via a rigid cyclic structure.

More specifically, the terminal group structure of the general formula (2) functions as a thermosetting group. This terminal group structure contributes as a substituent that imparts thermal flowability before curing, and during curing, can cause a curing reaction via a rigid cyclic structure. In this manner, it is possible to achieve both thermal flowability and heat resistance, which are conflicting properties. The curing reaction progresses even without an acid generator, and therefore, advantageous effects of the base generator can be fully achieved.

In addition, the terminal group structure of the general formula (3) can function as an adhesive group and a film-formability auxiliary group. By a terminal group structure having three adjacent hydroxy groups, as in the general formula (3), being contained, affinity with a substrate can be enhanced and favorable flatness can be exhibited, and by adhesiveness to a substrate being enhanced, it is possible to prevent the generation of pinholes in the film that occurs during film formation, delamination from the substrate, and recession (contraction) of a film edge.

Furthermore, in the inventive resist underlayer film material, the compound or resin (A) containing three adjacent hydroxy groups in some terminal group structures satisfies relationships a+b = 1.0, 0.70 ≤ a ≤ 0.99, and 0.01 ≤ b ≤ 0.30, where the "a" and the "b" respectively represent a proportion of the terminal group structure represented by the general formula (2) constituting the Y in the above-described general formula and a proportion of the terminal group structure represented by the general formula (3) constituting the Y. A compound or resin (A) containing three adjacent hydroxy groups in some terminal group structures, the compound or resin containing the terminal group structure represented by the general formula (2) and the terminal group structure represented by the general formula (3) in such proportions "a" and "b", can exhibit flatness, film-formability and etching properties with an appropriate balance without sacrificing either.

In this manner, the inventive resist underlayer film material makes it possible to form a resist underlayer film excellent in flatness and film-formability even on a substrate to be processed having portions that are particularly difficult to planarize, and the underlayer film can also exhibit appropriate etching properties.

The inventive resist underlayer film material can further contain, as optional components, components other than the essential components: the compound or resin (A) containing three adjacent hydroxy groups in some terminal group structures; and the organic solvent (B) .

In the following, each of the essential components and optional components of the inventive resist underlayer film material will be described in detail in turn.

### [(A) Compound or Resin Containing Three Adjacent Hydroxy Groups in Some Terminal Group Structures]

It can be assumed that, since the inventive resist underlayer film material has an excellent affinity with a substrate by virtue of containing a compound or resin (A) containing three adjacent hydroxy groups in some terminal group structures, it is possible to form a resist underlayer film having excellent film-formability even on a substrate to be processed having a complicated fine structure or substrates to be processed having various surface qualities. In particular, the material has excellent film-formability on a hydrophobic substrate treated with HMDS.

The compound or resin (A) containing three adjacent hydroxy groups in some terminal group structures preferably has a formula weight (molecular weight) of 300 to 3,000, particularly preferably 500 to 2,500 as a weight-average molecular weight in terms of polystyrene. When the molecular weight is 300 or more, film-formability is excellent, and there is no risk of apparatuses being contaminated due to increase in sublimation products during curing. When the molecular weight is 3,000 or less, high thermal flowability can be exhibited by the complex viscosity of the resin being decreased during baking, and excellent flatness and/or filling property can be exhibited. Note that, in the present invention, molecular weight can be weight-average molecular weight (Mw) in terms of polystyrene measured by gel permeation chromatography (GPC) using tetrahydrofuran as an eluent. Number-average molecular weight (Mn) and dispersity (Mw/Mn) can also be determined in this manner. The dispersity of the component (A) can be 1.0 to 2.5, but the dispersity of a compound (A) containing three adjacent hydroxy groups in some terminal group structures is preferably 1.0 to 1.5.

In the general formula (2), a broken line represents an attachment point. Z represents an (m+1)-valent aromatic group having 6 to 20 carbon atoms. Z represents an (m+1)-valent group having a structure in which m+1 hydrogen atoms have been removed from an aromatic compound having 6 to 20 carbon atoms. In this case, examples of the aromatic compound having 6 to 20 carbon atoms include benzene, naphthalene, phenanthrene, anthracene, pyrene, biphenyl, toluene, xylene, methylnaphthalene, and fluorene. From the viewpoints of imparting thermal flowability and availability of raw materials, benzene and naphthalene are preferable. "m" represents an integer of 1 to 5, and to achieve favorable flatness, "m" is preferably 1 to 3. A represents a single bond or -O-(CH₂)ₚ- and "p" represents an integer of 1 to 10. To achieve favorable flatness, A is preferably -OCH₂-, where p = 1.

Examples of preferable structures of the general formula (2) include the following.

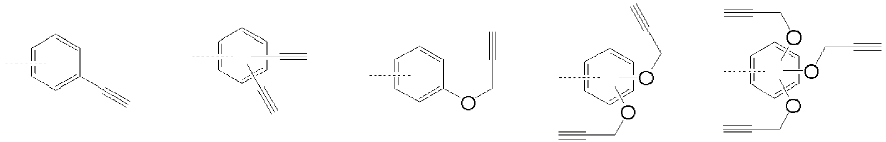

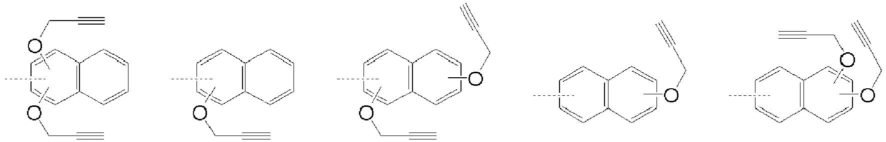

In particular, when the A in the general formula (2) is -OCH₂- in the component (A), film shrinkage (contraction) due to thermosetting can be suppressed, and a resist underlayer film having better flatness can be formed.

Examples of particularly preferable structures of the general formula (2) include the following formulae (4) to (6).

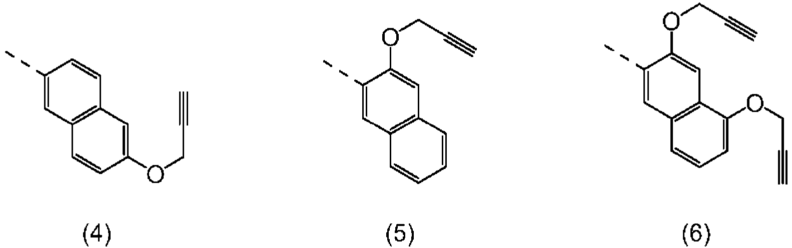

In the inventive resist underlayer film material, the terminal group structure represented by the general formula (2) can function as a thermosetting group. When the substituent A is -OCH₂-, which satisfies the relationship p = 1, and is present at a beta position of the naphthalene as in the formulae (4) to (6), given as examples of particularly preferable structures, the presumed mechanism is thermosetting via a cyclic structure as shown in the following reaction formula. In this case, before curing, the terminal group structure contributes as a substituent that imparts thermal flowability, and during curing, the structure causes a curing reaction via a rigid cyclic structure, and therefore, it is possible to achieve both thermal flowability and heat resistance, which are conflicting properties. The curing reaction progresses even without an acid generator, and therefore, advantageous effects of the base generator can be fully achieved.

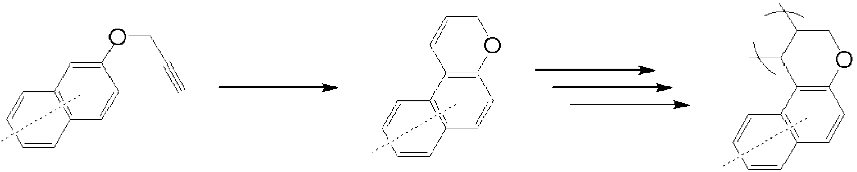

In the inventive resist underlayer film material, the terminal group structure represented by the general formula (3) can function as an adhesive group and a film-formability auxiliary group. When the component (A) has a terminal group structure having three adjacent hydroxy groups like the structure shown by the general formula (3), affinity with a substrate can be enhanced and favorable flatness can be exhibited, and by adhesiveness to a substrate being enhanced, it is possible to prevent the generation of pinholes in the film that occurs during film formation, delamination from the substrate, and recession (contraction) of a film edge.

Furthermore, "a" and "b" need to satisfy the relationships a+b = 1.0, 0.70 ≤ a ≤ 0.99, and 0.01 ≤ b ≤ 0.30 (when a+b is considered as 100, 70 ≤ a ≤ 99 and 1 ≤ b ≤ 30), where "a" and "b" respectively represent the proportions of the terminal group structures (terminal group ratios) of the general formulae (2) and (3) constituting the terminal group Y in the general formula (1). The relationships are more preferably 0.75 ≤ a ≤ 0.97 and 0.03 ≤ b ≤ 0.25, further preferably 0.80 ≤ a ≤ 0.95 and 0.05 ≤ b ≤ 0.20. By adjusting the terminal group ratios in the above ranges, both flatness and film-formability can be achieved while maintaining thermosetting property. The terminal group ratios can be calculated as "triple-bond-containing terminal group / phenolic-hydroxy-group-containing terminal group" by ¹H NMR.

In the general formula (1), W represents an n-valent organic group having 2 to 50 carbon atoms and "n" represents an integer of 1 to 10, and therefore, W is an organic group having a valency of 1 to 10 and having a structure in which 1 to 10 hydrogen atoms have been removed from an organic compound having 2 to 50 carbon atoms. A compound having an organic group W having 2 to 50 carbon atoms, the compound having a structure in which 1 to 10 hydrogen atoms have been added to the W, has at least one of each of the terminal structures represented by the general formulae (2) and (3), and the organic group represented by W may contain a linear, branched, or cyclic, saturated or unsaturated hydrocarbon group, an aromatic group, a heteroaromatic group, an ether group, a hydroxy group, an ester group, a keto group, an amino group, a halogen group, a sulfide group, a carboxy group, a sulfo group, an imide group, a cyano group, an aldehyde group, an imino group, a urea group, a carbamate group, a carbonate group, a nitro group, a sulfonic group, etc. To achieve both favorable flatness and sufficient thermosetting property, it is more preferable that "n" is 2 to 4.

By appropriately selecting the W, Y, and "n" in the compound of the general formula (1) according to the purpose, it is possible to adjust properties, such as the etching resistance, heat resistance, optical characteristics, polarity, and flexibility, of the resist underlayer film material. Among these, regarding optical characteristics, when the resist underlayer film material has appropriate optical characteristics at a wavelength of 193 nm, reflected light can be suppressed during exposure in multilayer ArF lithography, and excellent resolution can be achieved. Incidentally, to suppress reflected light, as the optical constants of the resist underlayer film material, it is preferable that the refractive index "n" is about 1.4 to 1.9 and the extinction coefficient "k" is about 0.1 to 0.5.

Furthermore, the W in the general formula (1) is preferably represented by the following general formula (7).

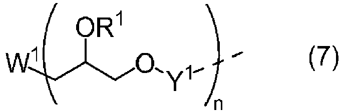

In the formula, a broken line represents an attachment point, R¹ represents a hydrogen atom or an alkyl group or an acyl group each having 1 to 20 carbon atoms, the alkyl group or the acyl group optionally containing an oxygen atom and/or a nitrogen atom, W¹ represents an n-valent organic group having 1 to 47 carbon atoms, Y¹ represents a single bond or a carbonyl group, and "n" represents an integer of 1 to 10.

When the W in the general formula (1) has a partial structure represented by the general formula (7), higher thermal flowability can be imparted to the inventive resist underlayer film material, and therefore, favorable flatness can be imparted.

In the general formula (7), examples of R¹ include a hydrogen atom, a methyl group, a methoxymethyl group, a 1-ethoxyethyl group, a 1-(2-ethylhexyloxy)ethyl group, a 2-tetrahydropyranyl group, an allyl group, a benzyl group, a propargyl group, a formyl group, an acetyl group, a propionyl group, a butyryl group, a hexanoyl group, an icosanoyl group, an acryloyl group, a methacryloyl group, a propioloyl group, a methoxyacetyl group, a benzoyl group, a 4-acetoamidobenzoyl group, a carbamoyl group, an N-methylcarbamoyl group, and an N,N-dimethylcarbamoyl group. Among these, a hydrogen atom, an acetyl group, and an acryloyl group are preferable, and a hydrogen atom is particularly preferable.

In the general formula (7), Y¹ represents a single bond or a carbonyl group, and Y¹ preferably represents a carbonyl group.

In the general formula (7), W¹ represents an n-valent organic group having 1 to 47 carbon atoms. The organic group of W¹, having 1 to 47 carbon atoms, may contain a linear, branched, or cyclic, saturated or unsaturated hydrocarbon group, an aromatic group, a heteroaromatic group, an ether group, a hydroxy group, an ester group, a keto group, an amino group, a halogen group, a sulfide group, a carboxy group, a sulfo group, an imide group, a cyano group, an aldehyde group, an imino group, a urea group, a carbamate group, a carbonate group, a nitro group, or a sulfonic group. "n" represents an integer of 1 to 10, and to achieve both favorable flatness and sufficient thermosetting property, "n" is preferably 2 to 4.

Preferable examples of the W¹ in the general formula (7) include structures of the following formulae.

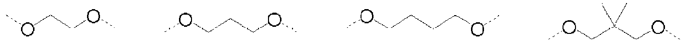

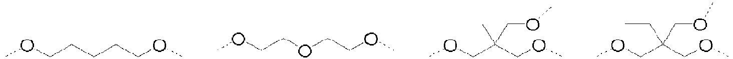

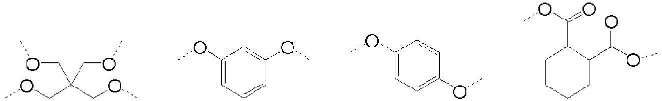

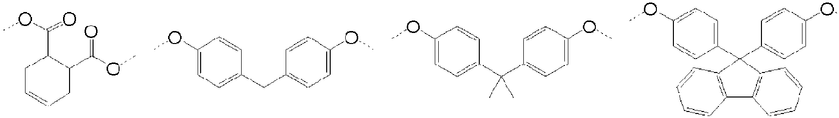

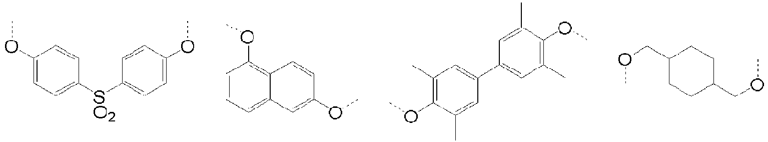

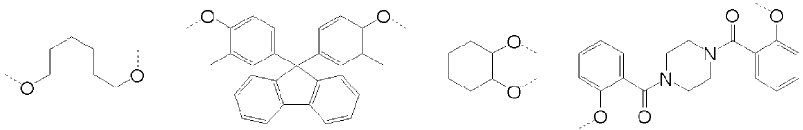

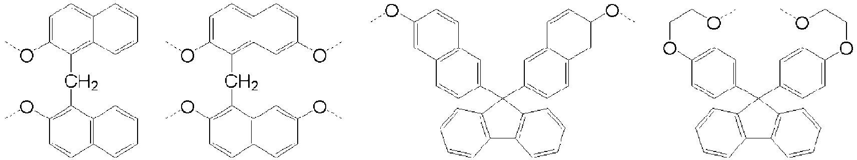

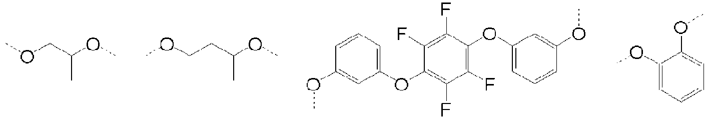

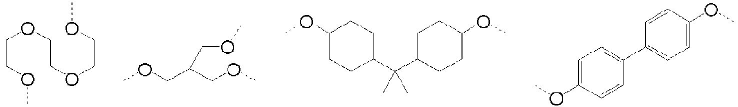

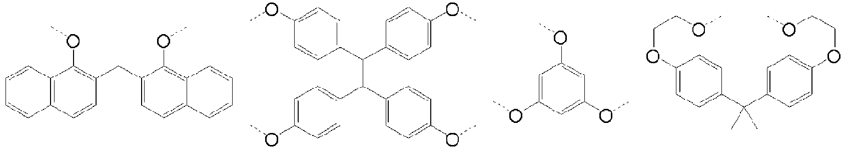

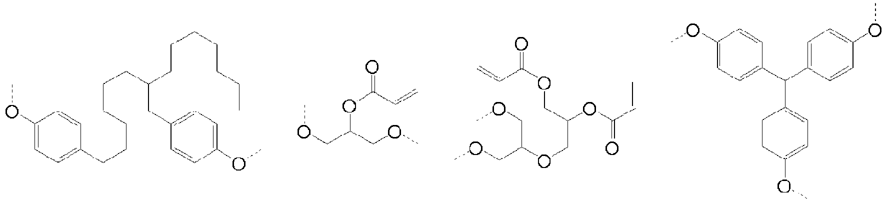

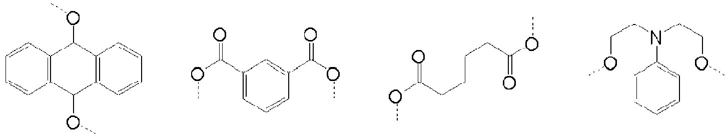

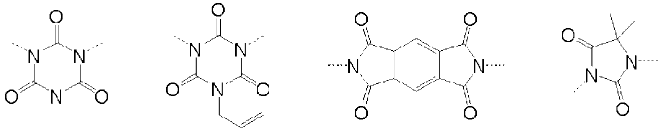

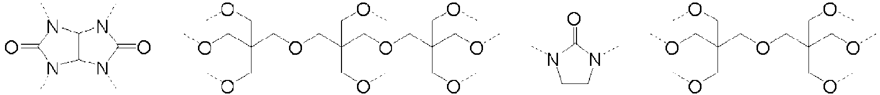

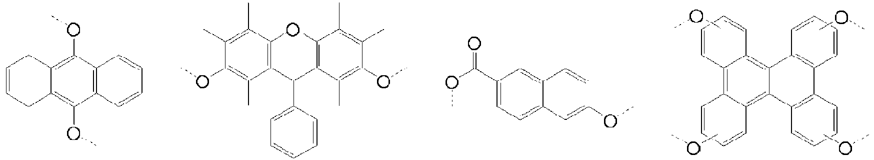

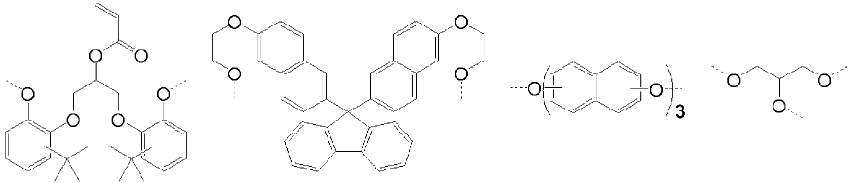

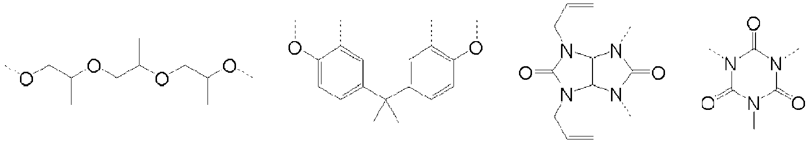

In the formulae, a broken line represents an attachment point.

When such a component (A) is contained, a resist underlayer film having even better film-formability and flatness can be achieved, and can be manufactured particularly easily.

By appropriately selecting the R¹, W¹, Y¹, and "n" according to the required performance or purpose of the present invention, it is possible to adjust properties such as etching resistance, heat resistance, optical constants, polarity, flexibility, and curability.

### [Method for Synthesizing Compound or Resin (A) Containing Three Adjacent Hydroxy Groups in Some Terminal Group Structures]

The compound or resin (A) containing three adjacent hydroxy groups in some terminal group structures can be obtained, for example, by a reaction of an epoxy compound containing a moiety corresponding to the W in the general formula (1) with a triple-bond-containing compound containing a moiety corresponding to the structure represented by the general formula (2) and with a compound containing a moiety corresponding to the structure represented by the general formula (3), the compound having three adjacent hydroxy groups. However, methods are not limited thereto. As specific examples, the Synthesis Examples in the Examples described later may be referred to.

In the inventive resist underlayer film material, one kind of the compound or resin represented by the general formula (1) may be used, or two or more kinds thereof may be used in mixture. Furthermore, it is possible to use a mixture containing the compound or resin represented by the general formula (1), other compounds, etc. When a mixture is to be used, it is preferable that the compound or resin represented by the general formula (1) takes up 10 mass% or more of all the solid contents, excluding the organic solvent (B), of the resist underlayer film material, more preferably 20 mass% or more. When the amount is 10 mass% or more, a sufficient blending effect can be achieved.

A resist underlayer film material containing the component (A) in such an amount makes it possible to form a resist underlayer film having better flatness and better film-formability, and can be manufactured particularly easily.

The inventive resist underlayer film material can further contain another substance in addition to the compound represented by the general formula (1). The substance for blending is, for example, mixed with the compound represented by the general formula (1) and serves to improve film-formability by spin-coating and the property of filling a stepped substrate. The substance that may be mixed in this case is not particularly limited, and a known substance can be used, but specifically, preferable are acrylic resins, styrene resins, phenolic resins, polyether resins, epoxy resins, and compounds having phenolic hydroxy groups. The contained amount of the substance for blending is preferably 1 to 100 parts by mass, more preferably 2 to 50 parts by mass, based on 100 parts by mass of the compound or resin represented by the general formula (1).

Incidentally, in the inventive resist underlayer film material, the contained amount of the component (A) can be, for example, 3 to 15 mass%.

### [(B) Organic Solvent]

The organic solvent (B) usable in the inventive resist underlayer film material is not particularly limited as long as the solvent is capable of dissolving one or more compounds or resins (A) each containing three adjacent hydroxy groups in some terminal group structures, and can preferably dissolve optional components, for example, the above-described substance for blending, and the base generator (C), surfactant (D), crosslinking agent (E), plasticizer (F), colorant (G), etc., described later.

Specifically, a solvent disclosed in paragraphs [0091] and [0092] of JP2007-199653A can be contained. Further specifically, preferably used are propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more thereof.

It is desirable to adjust the contained amount of the organic solvent according to the predetermined thickness of the resist underlayer film, and normally, the amount is 100 to 50,000 parts by mass based on 100 parts by mass of the compound or resin (A) (component (A)) containing three adjacent hydroxy groups in some terminal group structures.

Furthermore, in the inventive resist underlayer film material, the organic solvent (B) is preferably a mixture of one or more kinds of organic solvent having a boiling point of lower than 180°C and one or more kinds of organic solvent having a boiling point of 180°C or higher (hereinafter, also referred to as "high-boiling-point solvent").

Specific examples of the organic solvent having a boiling point of lower than 180°C include propylene glycol monomethyl ether acetate, propylene glycol monomethyl ether, propylene glycol monoethyl ether, propylene glycol monopropyl ether, 2-heptanone, cyclopentanone, and cyclohexanone.

The organic solvent having a boiling point of 180°C or higher is not particularly limited to hydrocarbons, alcohols, ketones, esters, ethers, chlorinated solvents, and so forth as long as the solvent is capable of dissolving the components of the inventive resist underlayer film material. Specific examples of the organic solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butylmethyl ether, triethylene glycol dimethyl ether, triethylene glycol monomethyl ether, triethylene glycol-n-butyl ether, triethylene glycol butylmethyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, etc. One of these may be used, or two or more thereof may be used in mixture.

The organic solvent having a boiling point of 180°C or higher may be appropriately selected, for example, from those given above, according to the temperature at which the inventive resist underlayer film material is to be heated and so forth. The organic solvent having a boiling point of 180°C or higher preferably has a boiling point of 180°C to 300°C, further preferably 200°C to 300°C. When the boiling point is as described, it can be assumed that there is no risk of volatilization rate being too high due to the boiling point being too low when baking (heating) is performed, and therefore, sufficient thermal flowability can be achieved at the time of film formation and it is possible to form a resist underlayer film excellent in filling property and/or flatness. In addition, when the boiling point is as described, there is no risk of the solvent remaining in the film without volatilizing even after baking because the boiling point is not too high, and therefore, there is no risk of the solvent adversely affecting the physical properties, such as etching resistance, of the film.

When the organic solvent having a boiling point of 180°C or higher is contained, the contained amount is preferably 1 to 30 parts by mass based on 100 parts by mass of the organic solvent having a boiling point of lower than 180°C. When the contained amount is as described, there are no risks that sufficient thermal flowability may not be imparted at the time of baking due to the contained amount being too small or that the solvent may remain in the film due to the contained amount being too large, leading to degradation of physical properties, such as etching resistance, of the film. Therefore, such an amount is preferable.

### [(C) Base Generator]

When the inventive resist underlayer film material contains a base generator, it is possible to form a resist underlayer film having excellent film-formability, even on a hydrophobic substrate that has been treated with HMDS, for example. To maximize the advantageous effects of the base generator, an acid generator is preferably not used.

In the present invention, a base generator refers to a compound whose chemical structure is altered by external stimulation, such as light and heat, to generate a base, and is also referred to as a "latent base", "base precursor", etc. The base to be generated may be a common base, such as ammonia or amine, or may also be a chemical species having a function of increasing the ionicity of the three adjacent hydroxy groups contained in some terminal group structures in the component (A).

The component (C) base generator is not particularly limited, and a known base generator can be used as necessary. However, since heating is to be performed when forming a film by using the inventive resist underlayer film material, and since it can be expected that film-formability can be enhanced by an increase in interaction with the substrate achieved by the three adjacent hydroxy groups contained in some terminal group structures in the component (A) exhibiting ionicity during heating, the base generator (C) is preferably a compound that exhibits basicity upon pyrolysis. This is because a resist underlayer film material containing such a component (C) can achieve both thermal flowability of a film formed from resist underlayer film material and interaction with the substrate when the contained amount of the component (C) is adjusted.

When a base generator that exhibits basicity upon pyrolysis (also referred to as a thermal base generator) is contained as the component (C) as described, the base to be generated is the cation that has become excessive in the system because of the evaporation or decomposition of the anion. Specific examples thereof include a triphenylsulfonium cation and a tetrabutylammonium cation. These cations increase the ionicity (polarity) of the three adjacent hydroxy groups contained in some terminal group structures in the component (A). Therefore, the ability of the resist underlayer film material to wet a substrate can be improved by interaction with polar groups, such as silanol groups, present on the surface, and recession (shrinkage) of a film edge and so forth can be suppressed even on a substrate that has been subjected to a hydrophobization treatment, such as HMDS treatment. Meanwhile, before heating, that is, before the base is generated, the above-described action does not occur, and therefore, the flowability of the resist underlayer film material itself can be maintained. Thus, a resist underlayer film having better film-formability can be formed.

Furthermore, it is more preferable that the base generator (B) is represented by any of the following general formulae (8), (9), and (10).

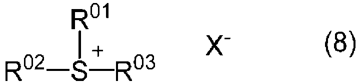

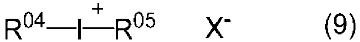

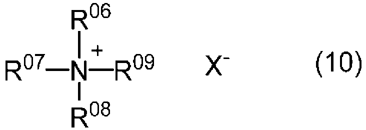

In the formulae, R⁰¹ to R⁰³ each independently represent a linear, branched, or cyclic alkyl group or alkenyl group, each having 1 to 10 carbon atoms, optionally having a substituent which is a heteroatom and optionally having an intervening heteroatom, or represent an aryl group or aralkyl group each having 6 to 18 carbon atoms, optionally having a substituent which is a heteroatom, and optionally having an intervening heteroatom, any two of R⁰¹, R⁰², and R⁰³ optionally being bonded to each other to form a ring together with the sulfur atom in the formula, X⁻ represents an organic or inorganic anion to be a counter ion, provided that X⁻ does not include OH⁻, R⁰⁴ and R⁰⁵ each independently represent an aryl group having 6 to 20 carbon atoms, part or all of hydrogen atoms of the aryl group optionally being substituted with a linear, branched, or cyclic alkyl group or alkoxy group each having 1 to 10 carbon atoms, and R⁰⁴ and R⁰⁵ optionally being bonded to each other to form a ring together with the iodine atom in the formula, and R⁰⁶, R⁰⁷, R⁰⁸, and R⁰⁹ each independently represent a hydrogen atom, represent a linear, branched, or cyclic alkyl group or alkenyl group each having 1 to 20 carbon atoms and optionally having a substituent which is a heteroatom and optionally having an intervening heteroatom, or represent an aryl group or aralkyl group each having 6 to 18 carbon atoms, optionally having a substituent which is a heteroatom, and optionally having an intervening heteroatom, any two of R⁰⁶, R⁰⁷, R⁰⁸, and R⁰⁹ optionally being bonded to each other to form a ring together with the nitrogen atom in the formula.

Specific examples of the R⁰¹, R⁰², and R⁰³ in the general formula (8) include: alkyl groups, such as a methyl group, an ethyl group, an n-propyl group, an isopropyl group, an n-butyl group, a tert-butyl group, a cyclopropyl group, a cyclopentyl group, a cyclohexyl group, a cyclopropylmethyl group, a 4-methylcyclohexyl group, a cyclohexylmethyl group, a norbornyl group, and an adamantyl group; alkenyl groups, such as a vinyl group, an allyl group, a propenyl group, a butenyl group, a hexenyl group, and a cyclohexenyl group; aryl groups, such as a phenyl group, a naphthyl group, and a thienyl group; and aralkyl groups, such as a benzyl group, a 1-phenylethyl group, and a 2-phenylethyl group. Aryl groups are preferable. Part of the hydrogen atoms in these groups may be substituted with a heteroatom, such as an oxygen atom, a sulfur atom, a nitrogen atom, and a halogen atom. An intervening heteroatom, such as an oxygen atom, a sulfur atom, and a nitrogen atom, may be contained. As a result, optionally formed or interposed are a hydroxy group, a cyano group, a carbonyl group, an ether bond, an ester bond, a sulfonic acid ester bond, a carbonate bond, a lactone ring, a sultone ring, a carboxylic anhydride, a haloalkyl group, etc.

In a case where any two of R⁰¹, R⁰², and R⁰³ are bonded to each other directly or via an oxygen atom, a methylene group, a sulfonic group, or a carbonyl group, examples of partial structures include those shown below, besides a dibenzothiophene skeleton and a phenoxathiin skeleton, but are not limited thereto. Note that, in the following formulae, the aromatic ring may have a substituent at any position.

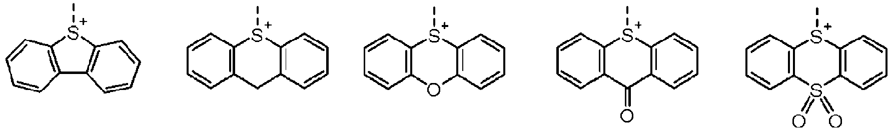

More specifically, examples of the sulfonium cation include triphenylsulfonium, 4-hydroxyphenyldiphenylsulfonium, bis(4-hydroxyphenyl)phenylsulfonium, tris(4-hydroxyphenyl)sulfonium, 4-tert-butoxyphenyldiphenylsulfonium, bis(4-tert-butoxyphenyl)phenylsulfonium, tris(4-tert-butoxyphenyl)sulfonium, 3-tert-butoxyphenyldiphenylsulfonium, bis(3-tert-butoxyphenyl)phenylsulfonium, tris(3-tert-butoxyphenyl)sulfonium, 4-tert-butylphenyldiphenylsulfonium, tris(4-tert-butylphenyl)sulfonium, 3,4-di-tert-butoxyphenyldiphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, 10-phenylphenoxathiinium, S-phenyldibenzothiophenium, 4-tert-butoxycarbonylmethyloxyphenyldiphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, (4-hydroxy-3,5-dimethylphenyl)diphenylsulfonium, and (4-n-hexyloxy-3,5-dimethylphenyl)diphenylsulfonium. Examples thereof further include 4-methacryloyloxyphenyldiphenylsulfonium, 4-acryloyloxyphenyldiphenylsulfonium, 4-methacryloyloxyphenyldimethylsulfonium, 4-acryloyloxyphenyldimethylsulfonium, (4-methacryloyloxy-3,5-dimethylphenyl)diphenylsulfonium, and (4-acryloyloxy-3,5-dimethylphenyl)diphenylsulfonium. More preferable examples thereof include triphenylsulfonium, 4-tert-butylphenyldiphenylsulfonium, 4-tert-butoxyphenyldiphenylsulfonium, 10-phenylphenoxathiinium, and S-phenyldibenzothiophenium. Among these, more preferable are triphenylsulfonium, 4-tert-butylphenyldiphenylsulfonium, and 4-tert-butoxyphenyldiphenylsulfonium.

Specific examples of the R⁰⁴ and R⁰⁵ in the general formula (9) include a phenyl group, a naphthyl group, a tolyl group, a xylyl group, a trimethylphenyl group, an ethylphenyl group, an isopropylphenyl group, a tert-butylphenyl group, a 1-adamantylphenyl group, a triisopropylphenyl group, a tricyclohexylphenyl group, a methoxyphenyl group, an ethoxyphenyl group, a butoxyphenyl group, a hydroxyphenyl group, a dihydroxyphenyl group, a trimethoxyphenyl group, a methylthiophenyl group, a biphenyl group, a fluorophenyl group, a difluorophenyl group, a bromophenyl group, an iodophenyl group, an N,N-diphenylaminophenyl group, an acetoxyphenyl group, an acetylaminophenyl group, a 2,2,2-trifluoroethoxyphenyl group, a (2-methoxyethoxy)phenyl group, a hydroxynaphthyl group, a dihydroxynaphthyl group, a 2,2,2-trifluoroethoxynaphthyl group, and (2-methoxyethoxy)naphthyl group, and these groups may have a substituent at any position. However, the R⁰⁴ and R⁰⁵ are not limited thereto.

As R⁰⁴ and R⁰⁵, preferable are an unsubstituted phenyl group or a phenyl group having a substituent at a para position of an iodine atom, the substituent being selected from a halogen atom, an alkyl group, and an alkoxy group. In particular, a phenyl group, a 4-tert-butylphenyl group, and a 4-fluorophenyl group are preferable.

In a case where R⁰⁴ and R⁰⁵ are bonded to each other directly or via an oxygen atom, a methylene group, a sulfonic group, or a carbonyl group, examples of partial structures include those shown below, but are not limited thereto. Note that, in the following formulae, the aromatic ring may have a substituent at any position.

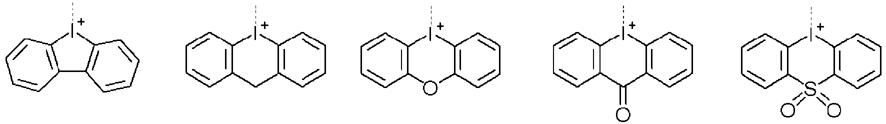

More specifically, examples of the iodonium cation include those shown below, but are not limited thereto. Note that, in the following formulae, tBu represents a tert-butyl group, and Ph represents a phenyl group.

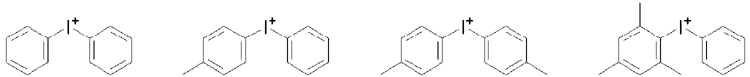

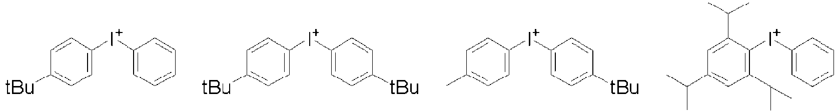

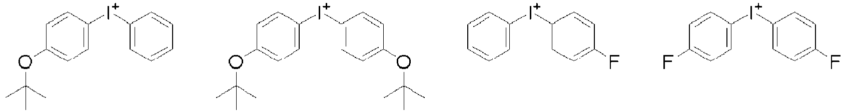

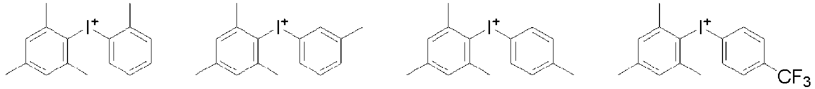

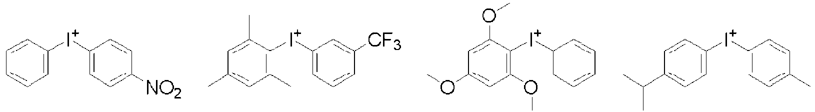

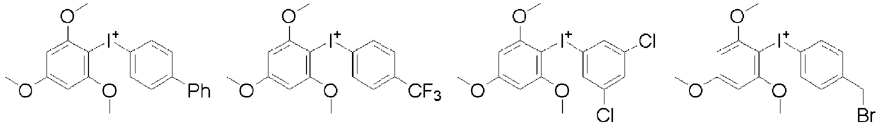

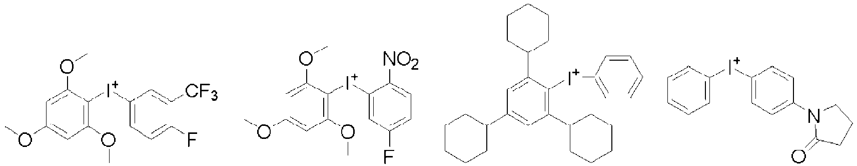

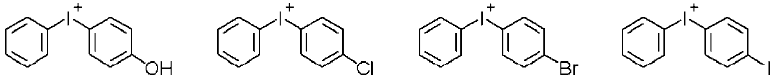

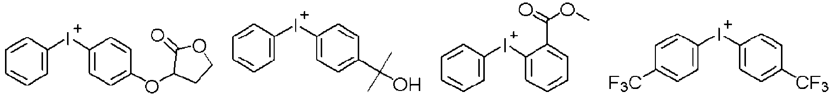

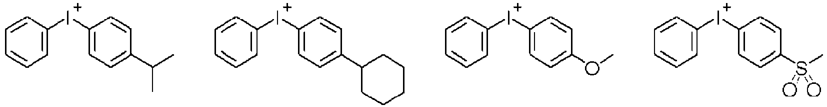

Examples of the ammonium cation represented by the general formula (10) include: ammonium cations having a protonated nitrogen atom of ammonia, primary, secondary, or tertiary aliphatic amines, mixed amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, etc.; and quaternary ammonium cations.

Specifically, examples of the primary aliphatic ammoniums include methylammonium, ethylammonium, n-propylammonium, isopropylammonium, n-butylammonium, isobutylammonium, sec-butylammonium, tert-butylammonium, pentylammonium, tert-amylammonium, cyclopentylammonium, hexylammonium, cyclohexylammonium, heptylammonium, octylammonium, nonylammonium, decylammonium, dodecylammonium, cetylammonium, aminomethylammonium, and 2-aminoethylammonium. Examples of the secondary aliphatic ammoniums include dimethylammonium, diethylammonium, di-n-propylammonium, diisopropylammonium, di-n-butylammonium, diisobutylammonium, di-sec-butylammonium, dipentylammonium, dicyclopentylammonium, dihexylammonium, dicyclohexylammonium, diheptylammonium, dioctylammonium, dinonylammonium, didecylammonium, didodecylammonium, dicetylammonium, methyl(methylamino)methylammonium, and methyl-2-(methylamino)ethylammonium. Examples of the tertiary aliphatic ammoniums include trimethylammonium, triethylammonium, tri-n-propylammonium, triisopropylammonium, tri-n-butylammonium, triisobutylammonium, tri-sec-butylammonium, tripentylammonium, tricyclopentylammonium, trihexylammonium, tricyclohexylammonium, triheptylammonium, trioctylammonium, trinonylammonium, tridecylammonium, tridodecylammonium, tricetylammonium, dimethyl(dimethylamino)methylammonium, and dimethyl(2-dimethylaminoethyl)ammonium.

Examples of the mixed ammoniums include dimethylethylammonium, methylpropylammonium, benzylammonium, phenethylammonium, and benzyldimethylammonium. Specific examples of the aromatic ammoniums and the heterocyclic ammoniums include anilinium derivatives (for example, anilinium, N-methylanilinium, N-ethylanilinium, N-propylanilinium, N,N-dimethylanilinium, 2-methylanilinium, 3-methylanilinium, 4-methylanilinium, an ethylanilinium with any substitution position, a propylanilinium with any substitution position, a trimethylanilinium with any substitution position, 2-nitroanilinium, 3-nitroanilinium, 4-nitroanilinium, 2,4-dinitroanilinium, 2,6-dinitroanilinium, 3,5-dinitroanilinium, and an N,N-dimethyltoluidinium with any substitution position), diphenyl(p-tolyl)ammonium, methyldiphenylammonium, triphenylammonium, an aminophenylammonium with any substitution position, naphthylammonium, an aminonaphthylammonium with any substitution position, pyrrolinium derivatives (for example, pyrrolinium, 2H-pyrrolinium, 1-methylpyrrolinium, 2,4-dimethylpyrrolinium, 2,5-dimethylpyrrolinium, and N-methylpyrrolinium), oxazolium derivatives (for example, oxazolium and isoxazolium), thiazolium derivatives (for example, thiazolium and isothiazolium), imidazolium derivatives (for example, imidazolium, 4-methylimidazolium, and 4-methyl-2-phenylimidazolium), pyrazolium derivatives, furazanium derivatives, pyrrolinium derivatives (for example, pyrrolinium and 2-methyl-1-pyrrolinium), pyrrolidinium derivatives (for example, pyrrolidinium, N-methylpyrrolidinium, pyrrolidinonium, and N-methylpyrrolidonium), imidazolinium derivatives, imidazolidinium derivatives, pyridinium derivatives (for example, pyridinium, methylpyridinium, ethylpyridinium, propylpyridinium, butylpyridinium, 4-(1-butylpentyl)pyridinium, dimethylpyridinium, trimethylpyridinium, triethylpyridinium, phenylpyridinium, 3-methyl-2-phenylpyridinium, 4-tert-butylpyridinium, diphenylpyridinium, benzylpyridinium, methoxypyridinium, butoxypyridinium, dimethoxypyridinium, 4-pyrrolidinopyridinium, 2-(1-ethylpropyl)pyridinium, aminopyridinium, and dimethylaminopyridinium), pyridazinium derivatives, pyrimidinium derivatives, pyrazinium derivatives, pyrazolinium derivatives, pyrazolidinium derivatives, piperidinium derivatives, piperazinium derivatives, morpholinium derivatives, indolinium derivatives, isoindolinium derivatives, 1H-indazolinium derivatives, quinolinium derivatives (for example, quinolinium), isoquinolinium derivatives, cinnolinium derivatives, quinazolinium derivatives, quinoxalinium derivatives, phthalazinium derivatives, purinium derivatives, pteridinium derivatives, carbazolium derivatives, phenanthridinium derivatives, acridinium derivatives, phenazinium derivatives, and 1,10-phenanthrolinium derivatives.

Furthermore, examples of the nitrogen-containing compounds having a carboxy group include carboxyphenylammonium, carboxyindolinium, and amino acid derivatives (for example, protonated products of nicotinic acid, alanine, arginine, aspartic acid, glutamic acid, glycine, histidine, isoleucine, glycylleucine, leucine, methionine, phenylalanine, threonine, lysine, 3-aminopyradine-2-carboxylic acid, and methoxyalanine). Examples of the nitrogen-containing compounds having a sulfonyl group include 3-pyridiniumsulfonic acid. Examples of the nitrogen-containing compounds having a hydroxy group, the nitrogen-containing compounds having a hydroxyphenyl group, and the alcoholic nitrogen-containing compounds include 2-hydroxypyridinium, a hydroxyanilinium with any substitution position, a hydroxy-methyl-anilinium with any substitution position, hydroxyquinolinium, dihydroxyquinolinium, 2-hydroxyethylammonium, bis(2-hydroxyethyl)ammonium, tris(2-hydroxyethyl)ammonium, ethylbis(2-hydroxyethyl)ammonium, diethyl(2-hydroxyethyl)ammonium, hydroxypropylammonium, bis(hydroxypropyl)ammonium, tris(hydroxypropyl)ammonium, 4-(2-hydroxyethyl)morpholinium, 2-(2-hydroxyethyl)pyridinium, 1-(2-hydroxyethyl)piperazinium, 1-[2-(2-hydroxyethoxy)ethyl]piperazinium, (2-hydroxyethyl)piperazinium, 1-(2-hydroxyethyl)pyrrolidinium, 1-(2-hydroxyethyl)-2-pyrrolidinonium, 2,3-dihydroxypropylpiperidinium, 2,3-dihydroxypropylpyrrolidinium, 8-hydroxyjulolidine, and 3-hydroxyquinuclidinium.

Specific examples of quaternary ammonium salts include tetramethylammonium, triethylmethylammonium, tetraethylammonium, tetrabutylammonium, tetraoctylammonium, didecyldimethylammonium, tridecylmethylammonium, hexadecyltrimethylammonium, stearyltrimethylammonium, benzyltrimethylammonium, benzyltriethylammonium, benzyltributylammonium, and 2-hydroxyethyltrimethylammonium.

As the ammonium cation, a quaternary ammonium cation is preferable, and a tetramethylammonium cation, a tetraethylammonium cation, and a tetrabutylammonium cation are particularly preferable.

In this case, the anion X⁻ in the general formulae (8), (9), and (10) is more preferably any anion selected from the group consisting of ions having structures represented by any of the following general formulae (11), (12), and (13), a chloride ion, a bromide ion, an iodide ion, a fluoride ion, a cyanide ion, a nitrate ion, and a nitrite ion.

R¹⁰-COO⁻ (11)

R¹¹-SO₃⁻ (12)

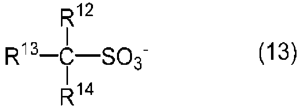

In the formulae, R¹⁰ represents a linear, branched, or cyclic alkyl group, a linear, branched, or cyclic alkenyl group, an aralkyl group, or an aryl group, each having 1 to 20 carbon atoms and optionally containing an ether group, an ester group, or a carbonyl group, one or more hydrogen atoms of the groups optionally being substituted with a halogen atom, a hydroxy group, a carboxy group, an amino group, and/or a cyano group, R¹¹ represents an aryl group having 6 to 20 carbon atoms, one or more hydrogen atoms of the aryl group optionally being substituted with a halogen atom, a hydroxy group, a carboxy group, an amino group, and/or a cyano group, and R¹², R¹³, and R¹⁴ each independently represent a hydrogen atom, a halogen atom other than a fluorine atom, or a linear, branched, or cyclic alkyl group, an alkenyl group, an aralkyl group, or an aryl group, each having 1 to 20 carbon atoms and optionally containing an ether group, an ester group, or a carbonyl group, one or more hydrogen atoms of the groups optionally being substituted with a halogen atom, a hydroxy group, a carboxy group, an amino group, and/or a cyano group, and two or more of R¹², R¹³, and R¹⁴ optionally being bonded to each other to form a ring.

Specific examples of the carboxylate anion represented by the general formula (11) include a formate anion, an acetate anion, a propionate anion, a butyrate anion, an isobutyrate anion, a valerate anion, an isovalerate anion, a pivalate anion, a hexanoate anion, an octanoate anion, a cyclohexanecarboxylate anion, a cyclohexylacetate anion, a laurate anion, a myristate anion, a palmitate anion, a stearate anion, a phenylacetate anion, a diphenylacetate anion, a phenoxyacetate anion, a mandelate anion, a benzoylformate anion, a cinnamate anion, a dihydroxycinnamate anion, a benzoate anion, a methylbenzoate anion, a salicylate anion, a naphthalenecarboxylate anion, an anthracenecarboxylate anion, an anthraquinonecarboxylate anion, a hydroxyacetate anion, a pivalate anion, a lactate anion, a methoxyacetate anion, a 2-(2-methoxyethoxy)acetate anion, a 2-(2-(2-methoxyethoxy)ethoxy)acetate anion, a diphenolate anion, a monochloroacetate anion, a dichloroacetate anion, a trichloroacetate anion, a trifluoroacetate anion, a pentafluoropropionate anion, a heptafluorobutyrate anion, and a 2-hydroxy-2,2-bis(trifluoromethyl)acetate anion. Examples thereof also include monoanions of dicarboxylic acids, such as succinic acid, tartaric acid, glutaric acid, pimelic acid, sebacic acid, phthalic acid, isophthalic acid, terephthalic acid, naphthalenedicarboxylic acid, cyclohexanedicarboxylic acid, and cyclohexenedicarboxylic acid.

Specific examples of arenesulfonate anions represented by the general formula (12) include benzenesulfonate, 4-toluenesulfonate, 2-toluenesulfonate, a xylenesulfonate with any substitution position, trimethylbenzenesulfonate, mesitylenesulfonate, 4-methoxybenzenesulfonate, 4-ethylbenzenesulfonate, 2,4,6-triisopropylbenzenesulfonate, 1-naphthalenesulfonate, 2-naphthalenesulfonate, anthraquinone-1-sulfonate, anthraquinone-2-sulfonate, 4-(4-methylbenzenesulfonyloxy)benzenesulfonate, 3,4-bis(4-methylbenzenesulfonyloxy)benzenesulfonate, 6-(4-methylbenzenesulfonyloxy)naphthalene-2-sulfonate, 4-phenyloxybenzenesulfonate, 4-diphenylmethylbenzenesulfonate, 2,4-dinitrobenzenesulfonate, and dodecylbenzenesulfonate.

Specific examples of alkanesulfonate anions represented by the general formula (13) include methanesulfonate, ethanesulfonate, propanesulfonate, butanesulfonate, pentanesulfonate, hexanesulfonate, cyclohexanesulfonate, octanesulfonate, and 10-camphorsulfonate.

Furthermore, it is preferable that a conjugate acid X-H of the X⁻ in the general formulae (8), (9), and (10) has a boiling point of 200°C or lower.

By appropriately selecting such a base generator that exhibits basicity upon pyrolysis (thermal base generator), basicity can be exhibited in accordance with the baking temperature of the resist underlayer film material, and both film-formability and flatness can be achieved. Furthermore, the entire quantity is decomposed or evaporates during baking and does not remain in the film after baking, and therefore, there is no risk of adversely affecting properties other than film-formability.

The X⁻ in the general formulae (8), (9), and (10) particularly preferably represents a trifluoroacetate anion, a pentafluoropropionate anion, a 2-hydroxy-2,2-bis(trifluoromethyl)acetate anion, a chloride ion, or a nitrate ion.

Examples of the base generator (C) include any combination of the aforementioned specific examples of the cation and specific examples of the anion, but are not limited thereto. Examples of preferable structures include the following structures. Note that, in the following formulae, tBu represents a tert-butyl group.

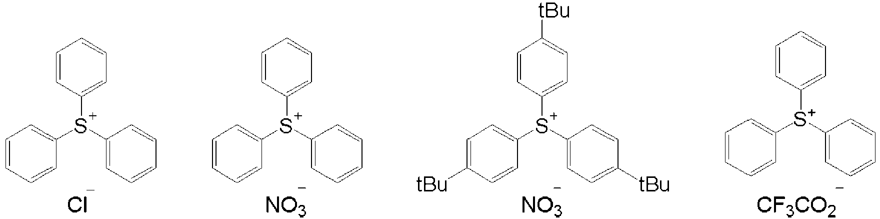

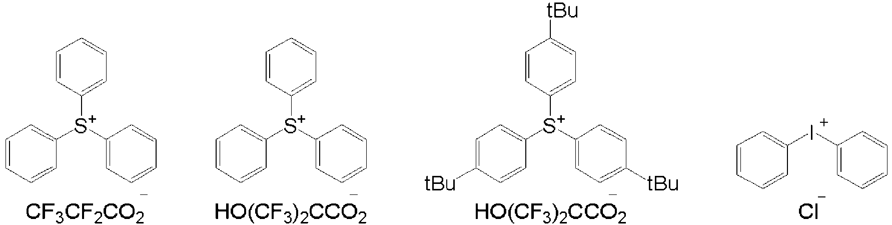

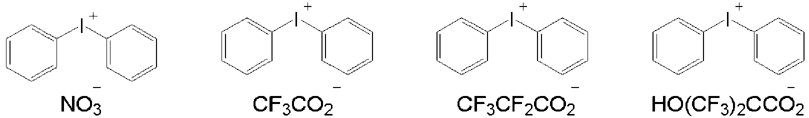

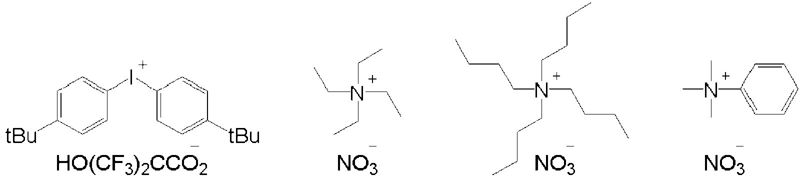

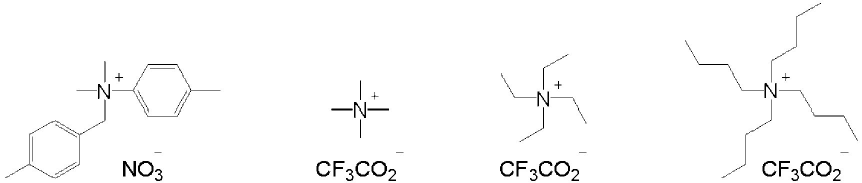

By using one kind of compound or a combination of two or more kinds of compounds as the base generator (C), it is possible to achieve basicity according to the baking temperature of the resist underlayer film material, and it is possible to adjust appropriately the balance between film-formability on a hydrophobic substrate and flatness. When the base generator (C) is to be contained, the contained amount is preferably 0.1 to 10 parts by mass, more preferably 0.3 to 3 parts by mass, based on 100 parts by mass of the compound or resin (A) (component (A)). When the contained amount of the base generator (C) is in the above-described range, a sufficient effect of improving film-formability can be achieved, and there are no risks of the problem of degradation in the in-plane uniformity of the film due to decomposition and sublimation or the problem of degradation in the curability of the compound or resin caused by the basicity.

### [(D) Surfactant]

In the inventive resist underlayer film material, a surfactant (D) can be contained for improving coatability in spin-coating. As the surfactant (D), it is possible to use, for example, a surfactant disclosed in paragraphs [0142] to [0147] of JP2009-269953A. When the surfactant (D) is contained, the contained amount is preferably 0.001 to 20 parts by mass, more preferably 0.01 to 10 parts by mass, based on 100 parts by mass of the component (A).

### [(E) Crosslinking Agent]

Moreover, in the inventive resist underlayer film material, a crosslinking agent (E) can also be contained so as to increase the curability and to further suppress intermixing with a film which is to be formed on the resist underlayer film. The crosslinking agent (E) is not particularly limited, and known various types of crosslinking agents can be widely used. Examples thereof include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol or alkoxymethyl-based crosslinking agents). When the crosslinking agent is contained, the contained amount is preferably 1 to 60 parts by mass, more preferably 10 to 50 parts by mass, based on 100 parts by mass of the component (A).

Specific examples of the melamine-based crosslinking agents include hexamethoxymethylmelamine, hexabutoxymethylmelamine, alkoxy- and/or hydroxy-substituted derivatives thereof, and partial self-condensates thereof. Specific examples of the glycoluril-based crosslinking agents include tetramethoxymethylglycoluril, tetrabutoxymethylglycoluril, alkoxy- and/or hydroxy-substituted derivatives thereof, and partial self-condensates thereof. Specific examples of the benzoguanamine-based crosslinking agents include tetramethoxymethylbenzoguanamine, tetrabutoxymethylbenzoguanamine, alkoxy- and/or hydroxy-substituted derivatives thereof, and partial self-condensates thereof. Specific examples of the urea-based crosslinking agents include dimethoxymethyldimethoxyethylene urea, alkoxy- and/or hydroxy-substituted derivatives thereof, and partial self-condensates thereof. Specific examples of the β-hydroxyalkylamide-based crosslinking agents include N,N,N',N'-tetra(2-hydroxyethyl)adipic amide. Specific examples of the isocyanurate-based crosslinking agents include triglycidylisocyanurate and triallylisocyanurate. Specific examples of the aziridine-based crosslinking agents include 4,4'-bis(ethyleneiminocarbonylamino)diphenylmethane and 2,2-bishydroxymethylbutanol-tris[3-(1-aziridinyl)propionate]. Specific examples of the oxazoline-based crosslinking agents include 2,2'-isopropylidene bis(4-benzyl-2-oxazoline), 2,2'-isoprolylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer. Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

To maximize the advantageous effects of the base generator, the polynuclear phenol-based crosslinking agent, which allows the crosslinking reaction to proceed without an acid generator, is more preferable. Furthermore, the polynuclear phenol-based crosslinking agent itself has a phenolic hydroxy group, and therefore, a higher effect of improving the film-formability can be expected by virtue of the action of the base generator. Specific examples of the polynuclear phenol-based crosslinking agents include compounds represented by the following general formula (14). 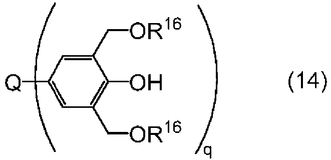 In the formula, Q represents a single bond or a q-valent hydrocarbon group having 1 to 20 carbon atoms. R¹⁶ represents a hydrogen atom or an alkyl group having 1 to 20 carbon atoms. "q" represents an integer of 1 to 5.

Q represents a single bond or a hydrocarbon group having a valency of "q" and having 1 to 20 carbon atoms. "q" represents an integer of 1 to 5, more preferably 2 or 3. Specific examples of Q include groups each of which is obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

Specific examples of the compound represented by the general formula (14) include the following compounds. In particular, from the viewpoints of enhancing the curability and film thickness uniformity of the resist underlayer film, hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene are particularly preferable.

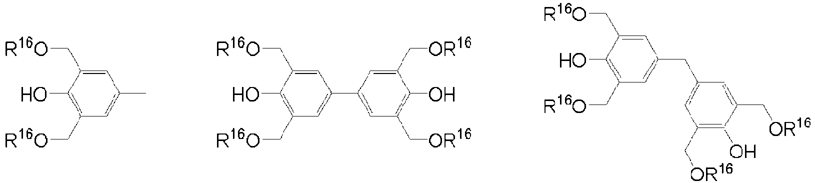

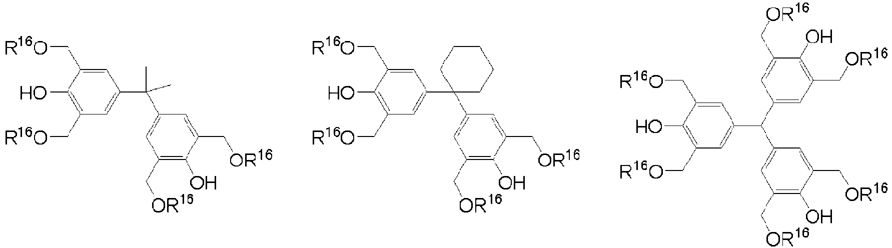

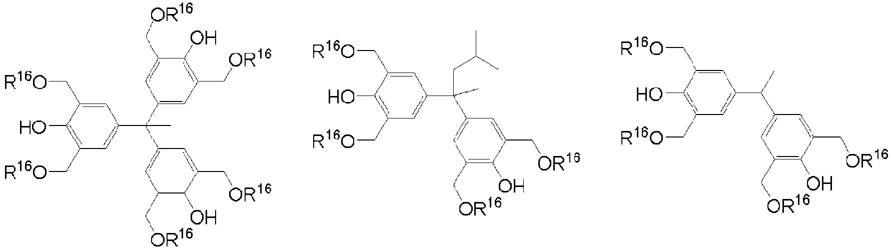

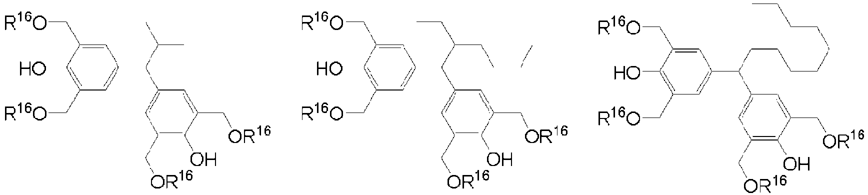

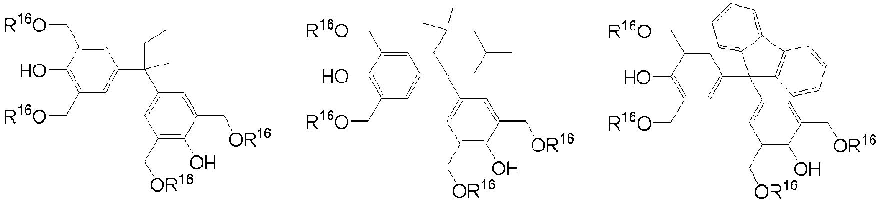

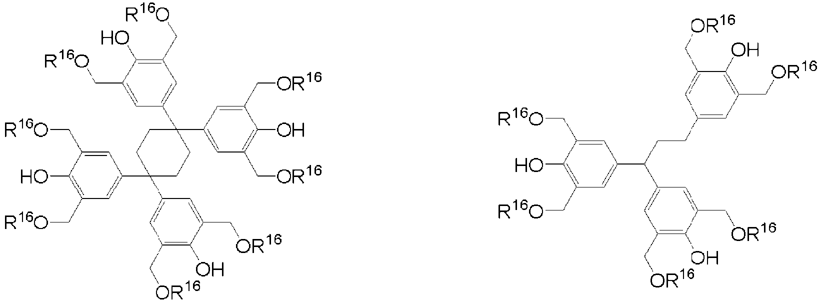

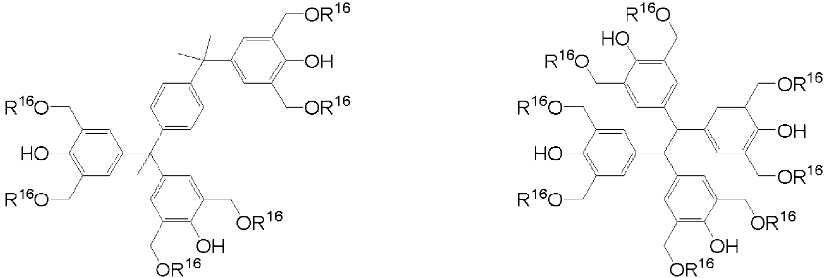

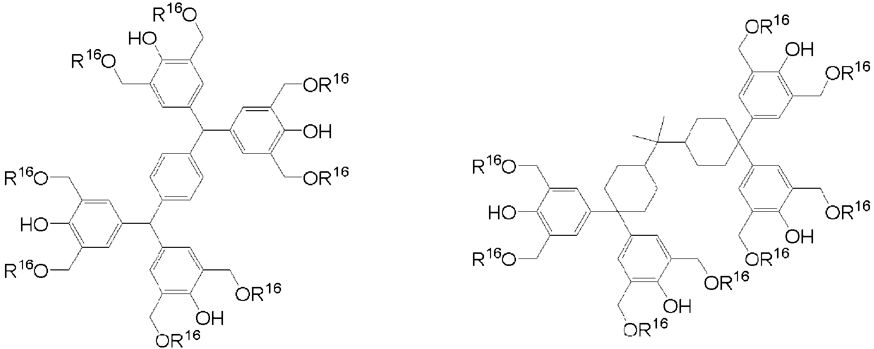

In the formulae, R¹⁶ is as defined above.

### [(F) Plasticizer]

Furthermore, in the inventive resist underlayer film material, a plasticizer (F) can be contained so as to further enhance the flatness and/or filling property. The plasticizer (F) is not particularly limited, and known various types of plasticizers can be widely used. Examples thereof include low-molecular-weight compounds, such as phthalic acid esters, adipic acid esters, phosphoric acid esters, trimellitic acid esters, and citric acid esters; and polymers such as polyethers, polyesters, and polyacetal-based polymers disclosed in JP2013-253227A. When the plasticizer (F) is contained, the contained amount is preferably 5 to 500 parts by mass, more preferably 10 to 200 parts by mass, based on 100 parts by mass of the component (A).

### [(G) Colorant]

Furthermore, in the inventive resist underlayer film material, a colorant (G) can be contained so as to further enhance the resolution upon patterning of the multilayer lithography. The colorant (G) is not particularly limited as long as it is a compound having an appropriate absorbance in the irradiation wavelength, and various known compounds can be widely used. Examples thereof include benzenes, naphthalenes, anthracenes, phenanthrenes, pyrenes, isocyanuric acids, and triazines. When the colorant (G) is contained, the contained amount is preferably 0.01 to 10 parts by mass, more preferably 0.1 to 5 parts by mass, based on 100 parts by mass of the component (A).

As described above, the inventive resist underlayer film material makes it possible to form a resist underlayer film excellent in flatness and film-formability even on a substrate to be processed having portions that are particularly difficult to planarize, such as a wide trench structure, in a fine patterning process according to a multilayer resist method, the underlayer film also being capable of exhibiting appropriate etching properties. Therefore, the inventive resist underlayer film material, the inventive patterning processes, and the inventive methods for forming a resist underlayer film can be used particularly suitably for multilayer resist processes that include the planarization of a substrate to be processed having a step or unevenness, and are extremely useful in fine patterning for manufacturing a semiconductor device. In particular, it is possible to provide a resist underlayer film material, a patterning process using the material, and a method for forming a resist underlayer film by using the material that make it possible to form a resist underlayer film which is excellent in flatness and can be formed without dependence on the substrate even on a substrate to be processed having portions that are particularly difficult to planarize, such as a wide trench structure, and furthermore, that can provide appropriate etching properties and optical characteristics in a fine patterning process according to a multilayer resist method in a semiconductor device manufacturing process, even when an acid generator is not contained. In particular, it is possible to suppress pinholes and edge shrinkage (recession) by the three adjacent hydroxy groups in the terminal structure represented by the general formula (3) in the compound or resin (A) exhibiting strong interaction with the substrate surface, even when a resist underlayer film is to be formed on a wafer having been subjected to a hydrophobization treatment, such as treatment with HMDS.

### <Patterning Process>

The present invention also provides a patterning process for forming a pattern in a substrate to be processed, including the steps of:
(I-1) applying the inventive resist underlayer film material onto a substrate to be processed to obtain a coating film and then heating the coating film to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(I-4) transferring the pattern to the resist underlayer film by dry-etching the resist underlayer film while using the resist upper layer film having the formed pattern as a mask; and
(I-5) forming the pattern in the substrate to be processed by processing the substrate to be processed while using the resist underlayer film having the formed pattern as a mask (2-layer resist process).

Furthermore, the present invention provides a patterning process for forming a pattern in a substrate to be processed (3-layer resist process), including the steps of:
(II-1) applying the inventive resist underlayer film material onto a substrate to be processed to obtain a coating film and then heating the coating film to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry-etching the resist middle layer film while using the resist upper layer film having the formed pattern as a mask;
(II-6) transferring the pattern to the resist underlayer film by dry-etching the resist underlayer film while using the resist middle layer film having the transferred pattern as a mask; and
(II-7) forming the pattern in the substrate to be processed by processing the substrate to be processed while using the resist underlayer film having the formed pattern as a mask.

In addition, the present invention provides a patterning process for forming a pattern in a substrate to be processed (4-layer resist process), including the steps of:
(III-1) applying the inventive resist underlayer film material onto a substrate to be processed to obtain a coating film and then heating the coating film to form a resist underlayer film;
(III-2) forming an inorganic hard mask middle layer film selected from the group consisting of a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry-etching the organic thin film and the inorganic hard mask middle layer film while using the resist upper layer film having the formed pattern as a mask;
(III-7) transferring the pattern to the resist underlayer film by dry-etching the resist underlayer film while using the inorganic hard mask middle layer film having the transferred pattern as a mask; and
(III-8) forming the pattern in the substrate to be processed by processing the substrate to be processed while using the resist underlayer film having the formed pattern as a mask.

The thickness of the resist underlayer film formed in the inventive patterning processes is appropriately selected, and is preferably 2 to 20,000 nm, particularly preferably 50 to 15,000 nm, for example. In the case of a resist underlayer film for a 3-layer process, it is possible to form thereon a resist middle layer film (middle layer film) containing silicon and a resist upper layer film containing no silicon. In the case of a resist underlayer film for a 2-layer process, it is possible to form thereon a resist upper layer film containing silicon or a resist upper layer film containing no silicon.

The inventive patterning processes can be used suitably for various types of multilayer resist processes, such as a silicon-containing 2-layer resist process, a 3-layer resist process using a silicon-containing middle layer film, a 4-layer resist process using a silicon-containing middle layer film and an organic thin film, or a 2-layer resist process including no silicon, for example.

As described above, the inventive resist underlayer film material makes it possible to form a resist underlayer film excellent in flatness and film-formability even on a substrate to be processed having portions that are particularly difficult to planarize, such as a wide trench structure, the underlayer film also being capable of exhibiting appropriate etching properties. Furthermore, a resist underlayer film formed from the inventive resist underlayer film material can exhibit high adhesiveness to a substrate to be processed. Therefore, according to the inventive patterning processes, a fine pattern can be formed in a substrate to be processed with high precision even if the substrate to be processed has portions where it is difficult to planarize a step.

### [3-Layer Resist Process]

The inventive patterning processes will be described below with reference to a 3-layer resist process, but the inventive patterning processes are not limited to this process. In this case, a pattern can be formed in a substrate by: forming a resist underlayer film on a substrate to be processed by using the inventive resist underlayer film material; forming a resist middle layer film on the resist underlayer film by using, for example, a resist middle layer film material containing silicon atoms; forming a resist upper layer film above the resist middle layer film by using a resist upper layer film material (photoresist material) of a photoresist composition to obtain a multilayer resist film; subjecting a pattern circuit region of the resist upper layer film to exposure and then development with a developer to form a resist pattern in the resist upper layer film; transferring the pattern to the resist middle layer film by dry-etching the resist middle layer film while using the resist upper layer film having the formed pattern as a mask; transferring the pattern to the resist underlayer film by etching the resist underlayer film while using the resist middle layer film having the formed pattern as a mask; and furthermore, processing the substrate while using the resist underlayer film having the formed pattern as a mask.

Since the resist middle layer film containing a silicon atom exhibits etching resistance to oxygen gas or hydrogen gas, the etching of the resist underlayer film performed while using the resist middle layer film as a mask as described above is preferably performed using an etching gas mainly containing oxygen gas or hydrogen gas.

In the inventive patterning processes, a pattern can also be formed in a substrate by at least: forming a resist underlayer film on a substrate to be processed by using the inventive resist underlayer film material; forming, as a resist middle layer film, an inorganic hard mask middle layer film selected from the group consisting of a silicon oxide film, a silicon nitride film, and a silicon oxynitride film on the resist underlayer film; forming a resist upper layer film on the inorganic hard mask middle layer film by using a resist upper layer film material including a photoresist composition; subjecting a pattern circuit region of the resist upper layer film to exposure and then development with a developer to form a resist pattern in the resist upper layer film; transferring the pattern to the inorganic hard mask middle layer film by dry-etching the inorganic hard mask middle layer film while using the obtained resist pattern as an etching mask; transferring the pattern to the resist underlayer film by dry-etching the resist underlayer film while using the obtained inorganic hard mask middle layer film pattern as an etching mask; and processing the substrate while using the obtained resist underlayer film pattern as a mask.

As described above, in a case where an inorganic hard mask middle layer film is formed on the resist underlayer film, a silicon oxide film, a silicon nitride film, or a silicon oxynitride film (SiON film) can be formed by a CVD method, an ALD method, etc. The method for forming the nitride film is disclosed in JP2002-334869A or WO2004/066377A1. The film thickness of the inorganic hard mask is, for example, 5 to 200 nm, preferably 10 to 100 nm, and in particular, an SiON film, which is highly effective as an antireflective coating, is most preferably used for ArF exposure.

As the silicon-containing resist middle layer film in the 3-layer resist process, a polysilsesquioxane-based middle layer film can be favorably used. A polysilsesquioxane-based middle layer film can be easily provided with an antireflective effect in excimer exposure, thus, reflected light can be suppressed during pattern exposure of the resist upper layer film, and such a film has an advantage of having excellent resolution. Particularly, for 193-nm light exposure, a material containing many aromatic groups is used as a resist underlayer film, so that the k-value and thus the substrate reflection are increased. However, the reflection can be suppressed by the resist middle layer film, and so the substrate reflection can be reduced to 0.5% or less. As the resist middle layer film having the antireflective effect, a polysilsesquioxane is preferably used, the polysilsesquioxane having anthracene for 248-nm and 157-nm light exposure, or a phenyl group or a light-absorbing group having a silicon-silicon bond for 193-nm light exposure in a pendant structure, and being crosslinked by an acid or heat.

In this case, forming a silicon-containing resist middle layer film by a spin-coating method is simpler and more advantageous regarding cost than a CVD method.

Examples of methods for forming a resist underlayer film by using the inventive resist underlayer film material include the inventive methods for forming a resist underlayer film, described in detail below, but are not limited thereto.

The resist upper layer film in a 3-layer resist film may be a positive type or a negative type, and any generally-used photoresist composition can be employed. When a resist upper layer film is formed with the photoresist composition, a spin-coating method can be favorably used in the same manner as when forming the resist underlayer film. After the spin-coating with the photoresist composition, pre-baking is performed, preferably at 60 to 180°C for 10 to 300 seconds. Then, light exposure, post-exposure baking (PEB), and development are performed according to conventional methods to obtain the resist pattern. Note that the thickness of the resist upper layer film is not particularly limited, but is preferably 30 to 500 nm, and particularly preferably 50 to 400 nm.

Examples of the exposure light include high-energy beams with a wavelength of 300 nm or less; specifically, excimer lasers of 248 nm, 193 nm, and 157 nm, soft X-ray of 3 to 20 nm, electron beam, X-ray with a wavelength of less than 3 nm, etc.

Next, etching is performed while using the obtained resist pattern as a mask. The etching of the resist middle layer film in a 3-layer process is performed using a fluorocarbon-based gas while using the resist pattern as a mask. Subsequently, the resist underlayer film is etched using an oxygen gas or a hydrogen gas while using the resist middle layer film pattern as a mask.

The subsequent etching of the substrate to be processed can also be performed according to a conventional method. For example, the substrate made of SiO₂, SiN, or silica-based low-dielectric insulating film is etched mainly with a fluorocarbon-based gas. The substrate made of p-Si, Al, or W is etched mainly with a chlorine- or bromine-based gas. When the substrate is processed by etching with a fluorocarbon-based gas, the silicon-containing middle layer film of the 3-layer process is removed together with the substrate processing. When the substrate is etched with a chlorine- or bromine-based gas, the silicon-containing middle layer film needs to be removed by additional dry etching or the like with a fluorocarbon-based gas after the substrate processing.

Note that, as the substrate to be processed, it is possible to use, for example, a substrate in which a layer to be processed is formed on a substrate. The substrate is not particularly limited, and a material, such as Si, α-Si, p-Si, SiO₂, SiN, SiON, W, TiN, and Al, being a different material from that of the layer to be processed can be used. Examples of the layer to be processed include: various Low-k films made of Si, SiO₂, SiON, SiN, p-Si, α-Si, W, TiN, W-Si, Al, Cu, Al-Si, etc.; and stopper films thereof. Generally, the layer can be formed to have a thickness of 50 to 10,000 nm, in particular, 100 to 5,000 nm. Furthermore, as the substrate to be processed, a substrate that has a static contact angle of 50° or more with water can be suitably used.

The inventive patterning processes are also suitable for processing a stepped substrate having a structure or step having a height of 30 nm or more. By filling and planarizing a stepped substrate by forming a resist underlayer film of the present invention thereon, the resist middle layer film and the resist upper layer film subsequently formed can be provided with a uniform film thickness, and the depth of focus margin (DOF) at the time of photolithography can be guaranteed easily. Therefore, the inventive patterning processes are very favorable. Furthermore, the inventive patterning processes are also useful when a substrate having a static contact angle of 50° or more with water is used as a substrate to be processed.

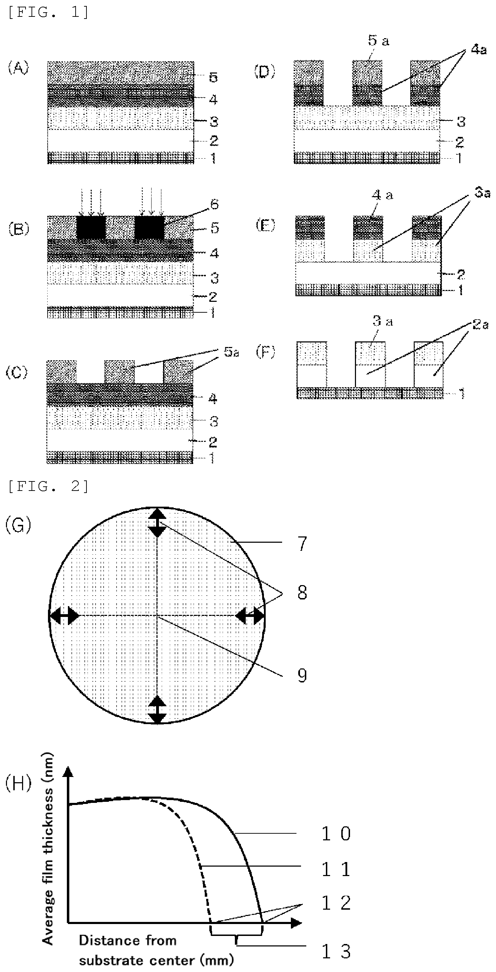

An example of the 3-layer resist process will be specifically described with reference to FIG. 1 as follows.

In the case of a 3-layer resist process, firstly, as shown in FIG. 1 (A), a resist underlayer film 3 is formed on a layer 2 to be processed laminated on a substrate 1 by using the inventive resist underlayer film material, then a resist middle layer film 4 is formed on the resist underlayer film 3, and a resist upper layer film 5 is formed thereon.

Subsequently, as shown in FIG. 1 (B), required portions 6 of the resist upper layer film are exposed and PEB (post-exposure baking) and development are performed to form a resist upper layer film pattern 5a (FIG. 1 (C)). The resist middle layer film 4 is etched using a CF-based gas while using the obtained resist upper layer film pattern 5a as a mask to form a resist middle layer film pattern 4a (FIG. 1 (D)). After the resist upper layer film pattern 5a is removed, the resist underlayer film 3 is etched with oxygen- or hydrogen-based plasma while using the obtained resist middle layer film pattern 4a as a mask to form a resist underlayer film pattern 3a (FIG. 1 (E)). Furthermore, after the resist middle layer film pattern 4a is removed, the layer 2 to be processed is processed by etching while using the resist underlayer film pattern 3a as a mask to form a pattern 2a in the layer 2 to be processed (FIG. 1 (F)).

In the case where an inorganic hard mask middle layer film is formed, the resist middle layer film 4 is the inorganic hard mask middle layer film, and in the case where an organic thin film is formed, an organic thin film layer is provided between the resist middle layer film 4 and the resist upper layer film 5. The organic thin film may be etched continuously and before the etching of the resist middle layer film 4. Alternatively, after the organic thin film is etched alone, the resist middle layer film 4 may be etched, for example, after an etching apparatus is changed.

### [4-Layer Resist Process]

The present invention can also be used suitably for a 4-layer resist process using an organic thin film. In this case, a pattern can be formed in a substrate by at least: forming a resist underlayer film on a substrate to be processed by using the inventive resist underlayer film material; forming an inorganic hard mask middle layer film selected from the group consisting of a silicon oxide film, a silicon nitride film, and a silicon oxynitride film on the resist underlayer film; forming an organic thin film on the inorganic hard mask middle layer film; forming a resist upper layer film on the organic thin film by using a resist upper layer film material including a photoresist composition; subjecting a pattern circuit region of the resist upper layer film to exposure and then development with a developer to form a resist pattern in the resist upper layer film; transferring the pattern to the organic thin film and the inorganic hard mask middle layer film by dry-etching the organic thin film and the inorganic hard mask middle layer film while using the obtained resist pattern as an etching mask; transferring the pattern to the resist underlayer film by dry-etching the resist underlayer film while using the obtained inorganic hard mask middle layer film pattern as an etching mask; and processing the substrate while using the obtained resist underlayer film pattern as a mask.

A photoresist film may be formed on the resist middle layer film as a resist upper layer film, or alternatively, an organic thin film may be formed on the resist middle layer film by spin-coating, and a photoresist film may be formed thereon as described above. When the SiON film is used as the resist middle layer film and an organic antireflective coating (BARC) having a light-absorbing group at the exposure wavelength is used as the organic thin film, two layers of antireflective coating including the SiON film and the organic thin film make it possible to suppress the reflection even in liquid immersion exposure at a high NA exceeding 1.0, in excimer exposure. Another merit of the organic thin film formation includes having an effect of reducing footing of the photoresist pattern immediately above the SiON. Another advantage is that when an adhesive film (ADL) excellent in affinity with the upper layer photoresist is used as the organic thin film, pattern collapse of the photoresist can be suppressed.

In the above, an example of a 3-layer resist process and an example of a 4-layer resist process have been given, but the inventive material for forming a resist underlayer film is also useful in a 2-layer resist process using a resist underlayer film and a resist upper layer film.

### <Method for Forming Resist Underlayer Film>

The present invention provides a method for forming a resist underlayer film that functions as an organic flat film employed in a semiconductor device manufacturing process, the method including:
spin-coating a substrate to be processed with the inventive resist underlayer film material; and
heating the substrate coated with the resist underlayer film material at a temperature of 100°C or higher to 600°C or lower for 10 to 600 seconds to cure the material and form a resist underlayer film.

The present invention also provides a method for forming a resist underlayer film that functions as an organic flat film employed in a semiconductor device manufacturing process, the method including:
spin-coating a substrate to be processed with the inventive resist underlayer film material; and
heating the substrate coated with the resist underlayer film material in an atmosphere having an oxygen concentration of 1 volume% or more to 21 volume% or less to cure the material and form a resist underlayer film.

Alternatively, the present invention provides a method for forming a resist underlayer film that functions as an organic flat film employed in a semiconductor device manufacturing process, the method including:
spin-coating a substrate to be processed with the inventive resist underlayer film material; and
heating the substrate coated with the resist underlayer film material in an atmosphere having an oxygen concentration of less than 1 volume% to cure the material and form a resist underlayer film.

In the inventive methods for forming a resist underlayer film, the above-described resist underlayer film material is applied onto a substrate to be processed by a spin-coating method or the like. By using a spin-coating method or the like, favorable filling property can be achieved. After the spin-coating, to evaporate the solvent and prevent mixing with the resist upper layer film or the resist middle layer film, baking is performed for promoting the crosslinking reaction. The baking is performed at a temperature of, for example, 100°C or higher to 600°C or lower, preferably 100°C or higher to 300°C or lower, more preferably 150°C or higher to 280°C or lower, for example, for 10 seconds to 600 seconds, preferably 10 to 300 seconds. By appropriately adjusting the baking temperature and time in the above ranges, it is possible to achieve the flatness, filling property, and curing property suitable for the purpose. When the baking temperature is 100°C or higher, the curing progresses sufficiently, and there is no risk of mixing with the upper layer film or the middle layer film. When the baking temperature is 600°C or lower, pyrolysis of the base resin can be suppressed, so that the film thickness does not decrease, and a uniform film surface can be achieved.

As the atmosphere during baking, either an oxygen-containing atmosphere (oxygen concentration: 1 volume% to 21 volume%), such as air, or a non-oxygen atmosphere, such as nitrogen, can be selected as necessary. For example, in a case where the substrate to be processed easily undergoes air oxidation, a cured film can be formed by heating in an atmosphere having an oxygen concentration of less than 1 volume% (non-oxygen atmosphere) to suppress damage to the substrate.

Furthermore, in the inventive patterning processes and the inventive methods for forming a resist underlayer film, a substrate having a structure or step having a height of 30 nm or more is also favorably used as the substrate to be processed. The inventive methods for forming a resist underlayer film are particularly useful when forming a planarizing organic film without gaps on a substrate having a structure or step having a height of 30 nm or more. Furthermore, the inventive methods are also useful when a substrate having a static contact angle of 50° or more with water is used as the substrate to be processed.

### EXAMPLES

Hereinafter, the present invention will be specifically described with reference to Examples and Comparative Examples. However, the present invention is not limited thereto. Note that the molecular weight and the dispersity were measured in the following manner. The weight-average molecular weight (Mw) and the number-average molecular weight (Mn) were measured by gel permeation chromatography (GPC) using tetrahydrofuran as an eluent in terms of polystyrene, and dispersity (Mw/Mn) was calculated on the basis of these results.

### Synthesis Examples: Synthesis of Compounds for Resist Underlayer Film Material

For the synthesis of each of compounds (A-1) to (A-10) and comparative compounds (R-1) and (R-2) for resist underlayer film materials, one of the epoxy compounds of compound group A ((a-1) to (a-5)), one of the triple-bond-containing compounds of compound group B ((b-1) to (b-3)), and one of the compounds having three adjacent hydroxy groups of compound group C ((c-1) and (c-2)) shown below were used. 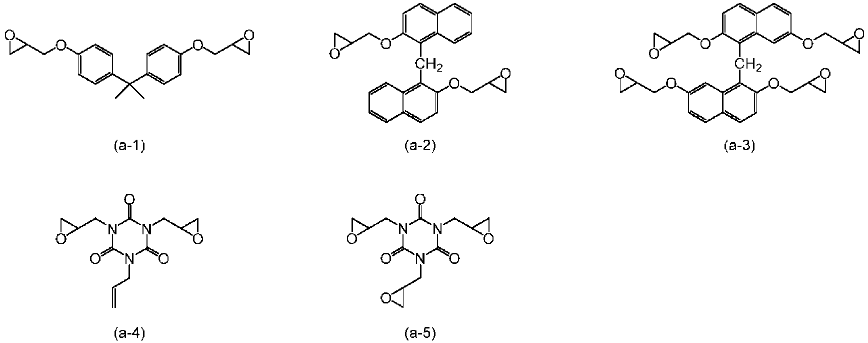 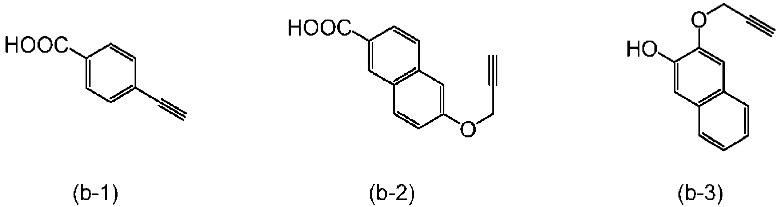 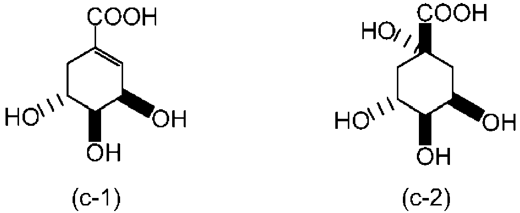 In the structural formulae, a bond represented by a thick solid line extends toward this side of the page, and a bond represented by a thick broken line extends toward the other side of the page. The same is true hereafter.

### [Synthesis Example 1] Synthesis of Compound (A-1)

10.21 g of the epoxy compound (a-1), 7.54 g of the triple-bond-containing carboxylic acid compound (b-1), 1.46 g of the compound (c-1) having three adjacent hydroxy groups, and 60 g of 2-methoxy-1-propanol were stirred under a nitrogen atmosphere at an inner temperature of 100°C to form a homogeneous solution. After that, to the homogeneous solution, 0.68 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-1). When the weight-average molecular weight (Mw) and dispersity (Mw/Mn) were measured by GPC, the following results were obtained. 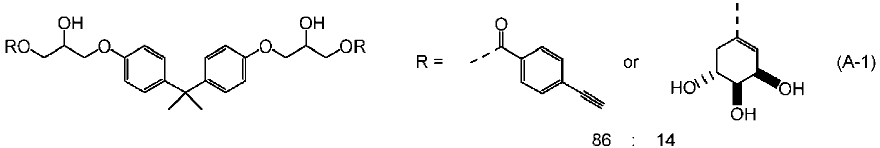 (A-1): Mw=910, Mw/Mn=1.01

In the structural formulae of R, a broken line having nothing depicted on one end represents an attachment point. The same is true hereafter.

### [Synthesis Example 2] Synthesis of Compound (A-2)

10.21 g of the epoxy compound (a-1), 12.22 g of the triple-bond-containing carboxylic acid compound (b-2), 1.15 g of the compound (c-2) having three adjacent hydroxy groups, and 60 g of 2-methoxy-1-propanol were stirred under a nitrogen atmosphere at an inner temperature of 100°C to form a homogeneous solution. After that, to the homogeneous solution, 0.68 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-2). When the weight-average molecular weight (Mw) and dispersity (Mw/Mn) were measured by GPC, the following results were obtained. 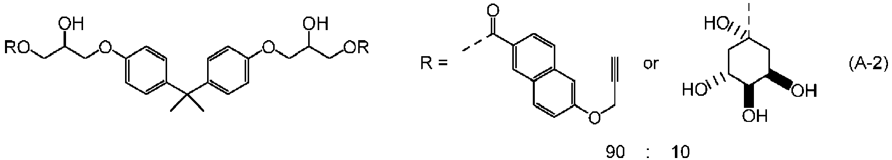 (A-2): Mw=970, Mw/Mn=1.02

### [Synthesis Example 3] Synthesis of Compound (A-3)

6.15 g of the epoxy compound (a-2), 3.29 g of the triple-bond-containing carboxylic acid compound (b-1), 1.44 g of the compound (c-2) having three adjacent hydroxy groups, and 60 g of 2-methoxy-1-propanol were stirred under a nitrogen atmosphere at an inner temperature of 100°C to form a homogeneous solution. After that, to the homogeneous solution, 0.34 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-3). When the weight-average molecular weight (Mw) and dispersity (Mw/Mn) were measured by GPC, the following results were obtained. 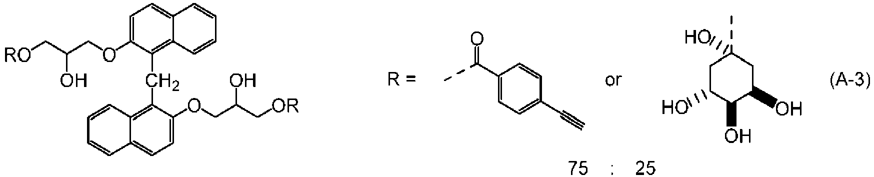 (A-3): Mw=1250, Mw/Mn=1.25

### [Synthesis Example 4] Synthesis of Compound (A-4)

6.15 g of the epoxy compound (a-2), 6.38 g of the triple-bond-containing carboxylic acid compound (b-2), 0.31 g of the compound (c-1) having three adjacent hydroxy groups, and 60 g of 2-methoxy-1-propanol were stirred under a nitrogen atmosphere at an inner temperature of 100°C to form a homogeneous solution. After that, to the homogeneous solution, 0.34 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-4). When the weight-average molecular weight (Mw) and dispersity (Mw/Mn) were measured by GPC, the following results were obtained. 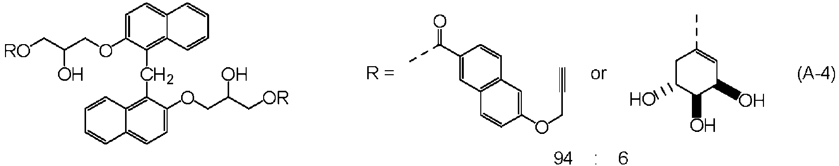 (A-4): Mw=1330, Mw/Mn=1.26

### [Synthesis Example 5] Synthesis of Compound (A-5)

4.95 g of the epoxy compound (a-3), 4.75 g of the triple-bond-containing carboxylic acid compound (b-2), 1.78 g of the compound (c-1) having three adjacent hydroxy groups, and 60 g of 2-methoxy-1-propanol were stirred under a nitrogen atmosphere at an inner temperature of 100°C to form a homogeneous solution. After that, to the homogeneous solution, 0.34 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-5). When the weight-average molecular weight (Mw) and dispersity (Mw/Mn) were measured by GPC, the following results were obtained. 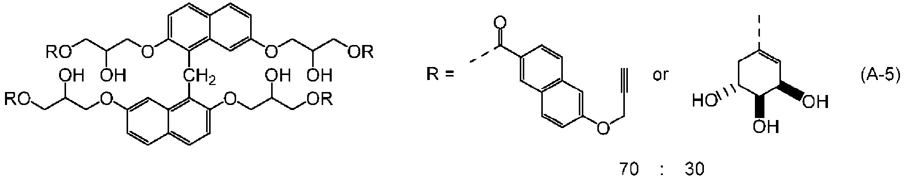 (A-5): Mw=2230, Mw/Mn=1.33

### [Synthesis Example 6] Synthesis of Compound (A-6)

4.95 g of the epoxy compound (a-3), 5.35 g of the triple-bond-containing carboxylic acid compound (b-3), 0.58 g of the compound (c-2) having three adjacent hydroxy groups, and 60 g of 2-methoxy-1-propanol were stirred under a nitrogen atmosphere at an inner temperature of 100°C to form a homogeneous solution.

After that, to the homogeneous solution, 0.34 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-6). When the weight-average molecular weight (Mw) and dispersity (Mw/Mn) were measured by GPC, the following results were obtained. 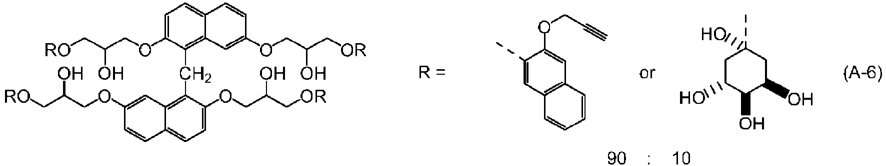 (A-6): Mw=2310, Mw/Mn=1.35

### [Synthesis Example 7] Synthesis of Compound (A-7)

8.44 g of the epoxy compound (a-4), 10.86 g of the triple-bond-containing carboxylic acid compound (b-2), 2.31 g of the compound (c-2) having three adjacent hydroxy groups, and 60 g of 2-methoxy-1-propanol were stirred under a nitrogen atmosphere at an inner temperature of 100°C to form a homogeneous solution. After that, to the homogeneous solution, 0.68 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-7). When the weight-average molecular weight (Mw) and dispersity (Mw/Mn) were measured by GPC, the following results were obtained. 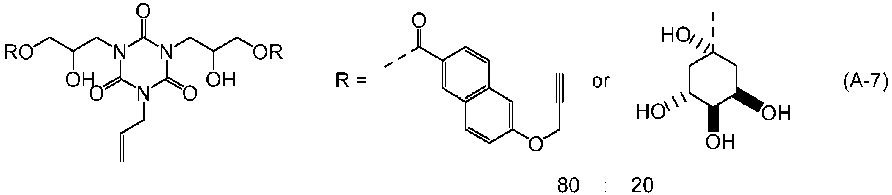 (A-7): Mw=750, Mw/Mn=1.05

### [Synthesis Example 8] Synthesis of Compound (A-8)

8.44 g of the epoxy compound (a-4), 11.30 g of the triple-bond-containing carboxylic acid compound (b-3), 0.52 g of the compound (c-1) having three adjacent hydroxy groups, and 60 g of 2-methoxy-1-propanol were stirred under a nitrogen atmosphere at an inner temperature of 100°C to form a homogeneous solution. After that, to the homogeneous solution, 0.68 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-8). When the weight-average molecular weight (Mw) and dispersity (Mw/Mn) were measured by GPC, the following results were obtained. 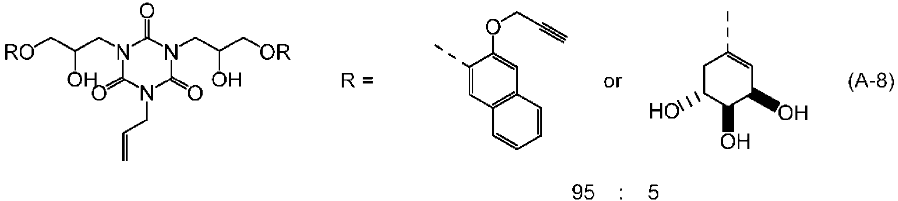 (A-8): Mw=800, Mw/Mn=1.06

### [Synthesis Example 9] Synthesis of Compound (A-9)

8.92 g of the epoxy compound (a-5), 18.73 g of the triple-bond-containing carboxylic acid compound (b-2), 1.25 g of the compound (c-1) having three adjacent hydroxy groups, and 60 g of 2-methoxy-1-propanol were stirred under a nitrogen atmosphere at an inner temperature of 100°C to form a homogeneous solution. After that, to the homogeneous solution, 1.02 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-9). When the weight-average molecular weight (Mw) and dispersity (Mw/Mn) were measured by GPC, the following results were obtained. 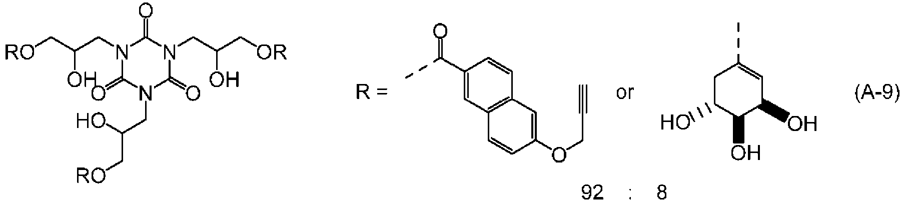 (A-9): Mw=1060, Mw/Mn=1.01

### [Synthesis Example 10] Synthesis of Compound (A-10)

8.92 g of the epoxy compound (a-5), 16.90 g of the triple-bond-containing carboxylic acid compound (b-2), 2.66 g of the compound (c-2) having three adjacent hydroxy groups, and 60 g of 2-methoxy-1-propanol were stirred under a nitrogen atmosphere at an inner temperature of 100°C to form a homogeneous solution. After that, to the homogeneous solution, 1.02 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a compound (A-10). When the weight-average molecular weight (Mw) and dispersity (Mw/Mn) were measured by GPC, the following results were obtained. 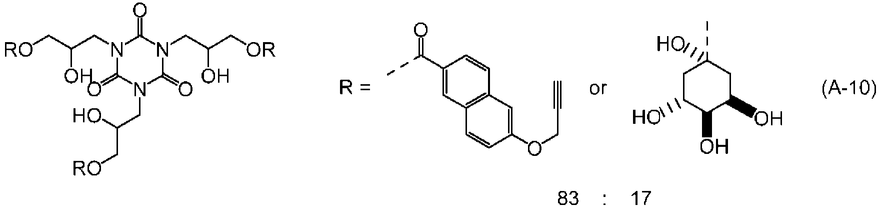 (A-10): Mw=1080, Mw/Mn=1.02

### [Comparative Synthesis Example 1] Synthesis of Comparative Compound (R-1)

9.43 g of the epoxy compound (a-5), 21.52 g of the triple-bond-containing carboxylic acid compound (b-2), and 60 g of 2-methoxy-1-propanol were stirred under a nitrogen atmosphere at an inner temperature of 100°C to form a homogeneous solution. After that, to the homogeneous solution, 1.00 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a comparative compound (R-1). When the weight-average molecular weight (Mw) and dispersity (Mw/Mn) were measured by GPC, the following results were obtained. 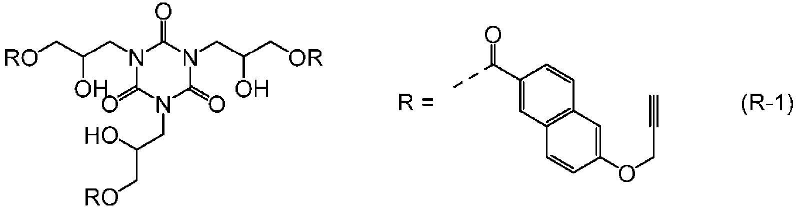 (R-1): Mw=1100, Mw/Mn=1.04

### [Comparative Synthesis Example 2] Synthesis of Comparative Compound (R-2)

9.42 g of the epoxy compound (a-5), 17.92 g of the triple-bond-containing carboxylic acid compound (b-2), 2.66 g of 3,4-dihydroxyphenylacetic acid, and 60 g of 2-methoxy-1-propanol were stirred under a nitrogen atmosphere at an inner temperature of 100°C to form a homogeneous solution. After that, to the homogeneous solution, 1.00 g of benzyltriethylammonium chloride was added, and the mixture was stirred at an inner temperature of 110°C for 12 hours. The mixture was cooled to room temperature, and then 200 ml of methyl isobutyl ketone was added thereto. The organic layer was washed twice with 100 g of a 1 mass% aqueous solution of ammonia, twice with 100 g of a 3% aqueous solution of nitric acid, and five times with 100 g of ultrapure water in this order. The organic layer was evaporated under reduced pressure to dryness to obtain a comparative compound (R-2). When the weight-average molecular weight (Mw) and dispersity (Mw/Mn) were measured by GPC, the following results were obtained. 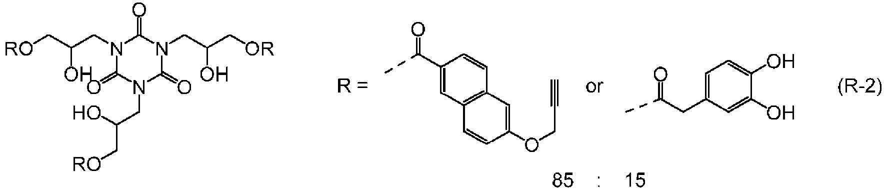 (R-2): Mw=1220, Mw/Mn=1.06

### [Comparative Synthesis Example 3] Synthesis of Comparative Polymer (R-3)

78.8 g of 2,7-dipropargyloxynaphthalene, 21.6 g of a 37% formalin solution, and 250 g of 1,2-dichloroethane were formed into a homogeneous solution under a nitrogen atmosphere at a solution temperature of 70°C. After that, to the homogeneous solution, 5 g of methanesulfonic acid was slowly added, and the mixture was stirred at a solution temperature of 80°C for 12 hours. The mixture was cooled to room temperature, and then 500 g of methyl isobutyl ketone was added thereto. The organic layer was washed five times with 200 g of pure water, and then was evaporated under reduced pressure to dryness. To the residue, 300 ml of THF was added, and a polymer was reprecipitated in 2000 ml of hexane. The precipitated polymer was separated by filtration and dried under reduced pressure to obtain a comparative polymer (R-3). When the weight-average molecular weight (Mw) and dispersity (Mw/Mn) were measured by GPC, the following results were obtained. 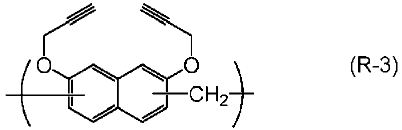 (R-3): Mw=2700, Mw/Mn=1.54

### Preparation of Resist Underlayer Film Materials (UDL-1 to -16, Comparative UDL-1 to -3)

One of the compounds (A-1) to (A-10), the comparative compounds (R-1) and (R-2), and a comparative polymer (R-3) was dissolved in propylene glycol monomethyl ether acetate (PGMEA), being the organic solvent (B), containing 0.1 mass% of PF6320 (manufactured by Omnova Solutions Inc.), being the surfactant (D), in the proportions shown in Table 1. Then, the solution was filtered through a 0.1-µm filter made of a fluorinated resin. Thus, each resist underlayer film material (UDL-1 to -10, comparative UDL-1 to -3) was prepared. In addition, each of resist underlayer film materials UDL-11 to -13 was prepared in the same manner as the resist underlayer film material UDL-9, except that one of compounds (BG1) to (BG3) was further used as a base generator and dissolved in the PGMEA together with the compound (A-9) in the proportions shown in Table 1. In addition, a resist underlayer film material UDL-14 was prepared in the same manner as the resist underlayer film material UDL-11, except that a compound (X1) was further used as a crosslinking agent. In addition, resist underlayer film materials UDL-15 and UDL-16 were prepared in the same manner as the resist underlayer film materials UDL-4 and UDL-6 respectively, except that 1,6-diacetoxyhexane (1,6-DAH), having a boiling point of 260°C, or tripropylene glycol monomethyl ether (TPM), having a boiling point of 242°C, was further used as a high-boiling-point solvent.

The compounds (X1), (BG1), (BG2), and (BG3) are shown below.

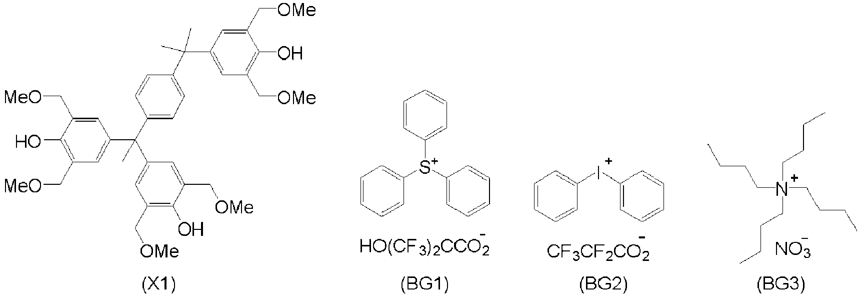

**[Table 1]**

| Resist underlayer film material | Compound, comparative compound, or comparative polymer (parts by mass) | Base generator (parts by mass) | Crosslinking agent (parts by mass) | High-boiling-point solvent (parts by mass) | PGMEA (parts by mass) |
|---|---|---|---|---|---|
| UDL-1 | A-1 (10) | - | - | - | 90 |
| UDL-2 | A-2 (10) | - | - | - | 90 |
| UDL-3 | A-3 (10) | - | - | - | 90 |
| UDL-4 | A-4 (10) | - | - | - | 90 |
| UDL-5 | A-5 (10) | - | - | - | 90 |
| UDL-6 | A-6 (10) | - | - | - | 90 |
| UDL-7 | A-7 (10) | - | - | - | 90 |
| UDL-8 | A-8 (10) | - | - | - | 90 |
| UDL-9 | A-9 (10) | - | - | - | 90 |
| UDL-10 | A-10 (10) | - | - | - | 90 |
| UDL-11 | A-9 (10) | BG1 (0.1) | - | - | 89.9 |
| UDL-12 | A-9 (10) | BG2 (0.1) | - | - | 89.9 |
| UDL-13 | A-9 (10) | BG3 (0.1) | - | - | 89.9 |
| UDL-14 | A-2 (10) | BG1 (0.1) | X1 (3) | - | 86.9 |
| UDL-15 | A-4 (10) | - | - | 1,6-DAH (5) | 85 |
| UDL-16 | A-6 (10) | - | - | TPM (5) | 85 |
| Comparative UDL-1 | R-1 (10) | - | - | - | 90 |
| Comparative UDL-2 | R-2 (10) | - | - | - | 90 |
| Comparative UDL-3 | R-3 (10) | - | - | - | 90 |

### Example 1: Film-Formability Evaluation (Examples 1-1 to 1-16, Comparative Examples 1-1 to 1-3)

Each of the resist underlayer film materials (UDL-1 to -16, comparative UDL-1 to -3) prepared above was applied onto each of a bare-Si substrate, a substrate treated with SiON, and a substrate treated with hexamethyldisilazane (HMDS), shown in Table 2, and the coating film thus obtained was baked at 250°C for 60 seconds to form each resist underlayer film, having a thickness of 100 nm. Each of the formed resist underlayer films was observed using an optical microscope (ECLIPSE L200 manufactured by NIKON CORPORATION) to check for coating abnormality. The HMDS treatment was performed under two sets of conditions: at 90°C for 60 seconds; and at 120°C for 120 seconds. Note that the contact angle of each substrate with water was measured with a contact angle meter (DM-701R manufactured by Kyowa Interface Science Co., Ltd.), and as a result, the bare-Si substrate had a contact angle of less than 15°, the SiON-treated substrate had a contact angle of 46°, the substrate treated with HMDS at 90°C for 60 seconds had a contact angle of 58°, and the substrate treated with HMDS at 120°C for 120 seconds had a contact angle of 66°. Regarding the HMDS-treated substrates, the substrate treated at a higher temperature for a longer time was more hydrophobic, and this is a condition under which it is difficult to ensure film-formability. In addition, in this evaluation, the film thickness is made thin to evaluate the coatability, and this is a severe evaluation condition, under which film formation abnormality occurs easily.

**[Table 2]**

| | Resist underlayer film material | Bare-Si substrate | Substrate treated with SiON | Substrate treated with HMDS at 90°C for 60 seconds | Substrate treated with HMDS at 120°C for 120 seconds |
|---|---|---|---|---|---|
| Example 1-1 | UDL-1 | No abnormality | No abnormality | No abnormality | No abnormality |
| Example 1-2 | UDL-2 | No abnormality | No abnormality | No abnormality | No abnormality |
| Example 1-3 | UDL-3 | No abnormality | No abnormality | No abnormality | No abnormality |
| Example 1-4 | UDL-4 | No abnormality | No abnormality | No abnormality | No abnormality |
| Example 1-5 | UDL-5 | No abnormality | No abnormality | No abnormality | No abnormality |
| Example 1-6 | UDL-6 | No abnormality | No abnormality | No abnormality | No abnormality |
| Example 1-7 | UDL-7 | No abnormality | No abnormality | No abnormality | No abnormality |
| Example 1-8 | UDL-8 | No abnormality | No abnormality | No abnormality | No abnormality |
| Example 1-9 | UDL-9 | No abnormality | No abnormality | No abnormality | No abnormality |
| Example 1-10 | UDL-10 | No abnormality | No abnormality | No abnormality | No abnormality |
| Example 1-11 | UDL-11 | No abnormality | No abnormality | No abnormality | No abnormality |
| Example 1-12 | UDL-12 | No abnormality | No abnormality | No abnormality | No abnormality |
| Example 1-13 | UDL-13 | No abnormality | No abnormality | No abnormality | No abnormality |
| Example 1-14 | UDL-14 | No abnormality | No abnormality | No abnormality | No abnormality |
| Example 1-15 | UDL-15 | No abnormality | No abnormality | No abnormality | No abnormality |
| Example 1-16 | UDL-16 | No abnormality | No abnormality | No abnormality | No abnormality |
| Comparative Example 1-1 | Comparative UDL-1 | No abnormality | Some pinhole defects | Some pinhole defects | Countless pinhole defects |
| Comparative Example 1-2 | Comparative UDL-2 | No abnormality | No abnormality | No abnormality | Countless pinhole defects |
| Comparative Example 1-3 | Comparative UDL-3 | No abnormality | No abnormality | No abnormality | No abnormality |

As shown in Table 2, in Examples 1-1 to 1-16, where the inventive resist underlayer film materials were used, uniform resist underlayer films having no coating abnormality were successfully formed in the cases of the bare-Si substrates, and also the SiON-treated substrates, the substrates treated with HMDS at 90°C for 60 seconds, and the substrates treated with HMDS at 120°C for 120 seconds. During the baking of the films, in Comparative Examples 1-1 and 1-2, countless pinholes were generated on the substrates treated with HMDS at 120°C for 120 seconds, and coating abnormality was observed. From the above, it can be seen that film-formability on the substrate was successfully improved by introducing, as some of the terminal group structures, a terminal group structure having three adjacent hydroxy groups as in the general formula (3) without using a combination of a compound containing a phenolic hydroxy group and a base generator as disclosed in JP2023-180781A. Meanwhile, in Comparative Example 1-3, where a polymer was contained, films were successfully formed on the SiON-treated substrate and the HMDS substrates as well.

### Example 2: Edge Recession Evaluation (Examples 2-1 to 2-16, Comparative Examples 2-1 to 2-3)

Each of the resist underlayer film materials (UDL-1 to -16, comparative UDL-1 to -3) prepared above was respectively applied with an edge-cut width of 2 mm onto a 12-inch bare-Si substrate and onto a 12-inch substrate treated with HMDS at 120°C for 120 seconds, and the obtained coating film was baked at 250°C for 60 seconds to form a substrate 7 coated with a resist underlayer film (organic film) having a film thickness of 100 nm, as shown in FIG. 2 (G). For each substrate, the formed resist underlayer film was measured in four places in the range between a radius of 145 mm to 149 mm from the substrate center 9 at intervals of 0.1 mm (8 in FIG. 2 (G)) by using a film thickness measurement apparatus (Atlas-XP⁺ manufactured by Onto Innovation Inc.). FIG. 2 (H) shows the average film thickness plot 10 on the bare-Si substrate and the average film thickness plot 11 on the HMDS substrate. As shown here, the point at which the average film thickness was 0 nm was specified as a film edge 12, and the difference between the film edge positions on the bare-Si substrate and the HMDS-treated substrate was determined as an edge recession distance 13. The results are shown in Table 3. It can be considered that, the smaller the edge recession distance 13, the better the coatability on the HMDS substrate.

**[Table 3]**

| | Resist underlayer film material | Distance from substrate center to film edge | | Edge recession distance: a-b (mm) |
|---|---|---|---|---|
| | | Bare-Si substrate: a (mm) | HMDS-treated substrate: b (mm) | |
| Example 2-1 | UDL-1 | 148.0 | 148.0 | 0.0 |
| Example 2-2 | UDL-2 | 147.9 | 147.7 | 0.2 |
| Example 2-3 | UDL-3 | 147.9 | 147.8 | 0.1 |
| Example 2-4 | UDL-4 | 148.1 | 148.0 | 0.1 |
| Example 2-5 | UDL-5 | 148.0 | 148.0 | 0.0 |
| Example 2-6 | UDL-6 | 148.0 | 147.9 | 0.1 |
| Example 2-7 | UDL-7 | 148.0 | 148.0 | 0.0 |
| Example 2-8 | UDL-8 | 148.1 | 148.0 | 0.1 |
| Example 2-9 | UDL-9 | 147.9 | 147.8 | 0.1 |
| Example 2-10 | UDL-10 | 147.9 | 147.9 | 0.0 |
| Example 2-11 | UDL-11 | 148.0 | 148.0 | 0.0 |
| Example 2-12 | UDL-12 | 147.9 | 147.9 | 0.0 |
| Example 2-13 | UDL-13 | 148.1 | 148.1 | 0.0 |
| Example 2-14 | UDL-14 | 148.1 | 148.1 | 0.0 |
| Example 2-15 | UDL-15 | 147.9 | 147.8 | 0.1 |
| Example 2-16 | UDL-16 | 148.0 | 147.9 | 0.1 |
| Comparative Example 2-1 | Comparative UDL-1 | 148.0 | <145.0 | >3.0 mm |
| Comparative Example 2-2 | Comparative UDL-2 | 148.0 | 146.5 | 1.5 |
| Comparative Example 2-3 | Comparative UDL-3 | 147.9 | 147.9 | 0.0 |

As shown in Table 3, in Examples 2-1 to 2-16, where used were the inventive resist underlayer film materials, that is, compounds having, as some terminal group structures, a terminal group structure having three adjacent hydroxy groups as in the general formula (3), the edge recession distance was generally 0.2 mm or less, and also taking errors in film thickness measurement into consideration, it can be assumed that there was almost no film edge recession. In Comparative Examples 2-1 and 2-2, there was considerable film edge recession on the HMDS-treated substrates, and it was not possible to observe the film edge within the measurement range. From the above, it can be seen that the present invention is useful for improving film edge recession on an HMDS substrate without using a combination of a compound containing a phenolic hydroxy group and a base generator as disclosed in JP2023-180781A. Meanwhile, in Comparative Example 2-3, where a polymer was contained, film edge recession on the HMDS substrate did not occur.

### Example 3: Filling Property Evaluation (Examples 3-1 to 3-16, Comparative Examples 3-1 to 3-3)

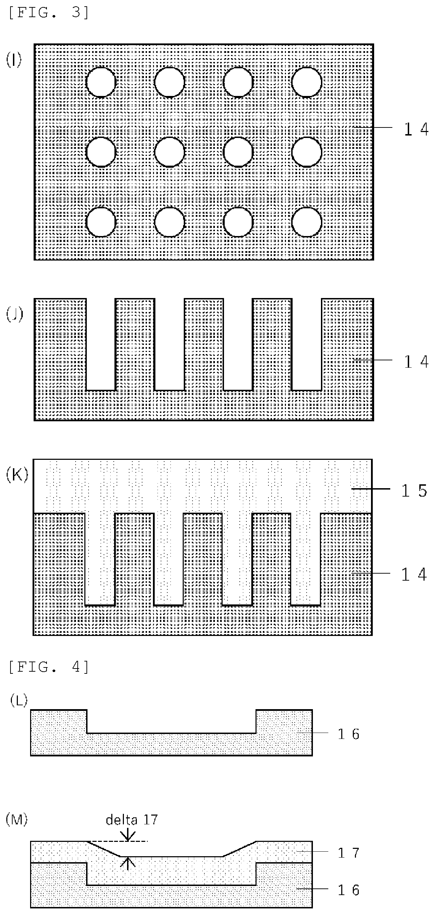

Each of the resist underlayer film materials (UDL-1 to -16, comparative UDL-1 to -3) prepared above was respectively applied onto an SiO₂ wafer substrate having a dense hole pattern (hole diameter: 0.16 µm, hole depth: 0.50 µm, distance between the centers of two adjacent holes: 0.32 µm) and baked at 250°C for 60 seconds to form a resist underlayer film. The substrate used was a base substrate 14 (SiO₂ wafer substrate) having a dense hole pattern as shown in FIG. 3 (I) (top view) and (J) (sectional view). The sectional profile of each wafer substrate obtained was observed with a scanning electron microscope (SEM) to check whether or not the holes were filled with the resist underlayer film 15 without voids (space). The results are shown in Table 4. If a resist underlayer film material having poor filling property is used, voids occur inside the holes in this evaluation. When a resist underlayer film material having favorable filling property is used, in this evaluation, the holes are filled with the resist underlayer film without voids as shown in FIG. 3 (K).

**[Table 4]**

| | Resist underlayer film material | Presence or absence of voids |
|---|---|---|
| Example 3-1 | UDL-1 | Absent |
| Example 3-2 | UDL-2 | Absent |
| Example 3-3 | UDL-3 | Absent |
| Example 3-4 | UDL-4 | Absent |
| Example 3-5 | UDL-5 | Absent |
| Example 3-6 | UDL-6 | Absent |
| Example 3-7 | UDL-7 | Absent |
| Example 3-8 | UDL-8 | Absent |
| Example 3-9 | UDL-9 | Absent |
| Example 3-10 | UDL-10 | Absent |
| Example 3-11 | UDL-11 | Absent |
| Example 3-12 | UDL-12 | Absent |
| Example 3-13 | UDL-13 | Absent |
| Example 3-14 | UDL-14 | Absent |
| Example 3-15 | UDL-15 | Absent |
| Example 3-16 | UDL-16 | Absent |
| Comparative Example 3-1 | Comparative UDL-1 | Absent |
| Comparative Example 3-2 | Comparative UDL-2 | Absent |
| Comparative Example 3-3 | Comparative UDL-3 | Present |

As shown in Table 4, each of the inventive resist underlayer film materials used in Examples 3-1 to 3-16 was capable of filling the hole pattern without voids, and it was found that the inventive materials were excellent in filling property. On the other hand, in Comparative Example 3-3, filling failure occurred, which is thought to result from insufficient thermal flowability due to the material containing a polymer different from the component (A) contained in the inventive resist underlayer film material.

### Example 4: Flatness Evaluation (Examples 4-1 to 4-16, Comparative Examples 4-1 to 4-3)

Each of the resist underlayer film materials (UDL-1 to 16, comparative UDL-1 to -3) prepared above was respectively applied onto a base substrate 16 (SiO₂ wafer substrate) having a giant isolated trench pattern (FIG. 4 (L), trench width: 10 µm, trench depth: 0.1 µm), and baked at 250°C for 60 seconds. Then, a step (delta 17 in FIG. 4 (M)) between the trench portion and the non-trench portion of the resist underlayer film 17 was observed using an atomic force microscope (AFM) NX10 manufactured by Park Systems. The results are shown in Table 5. In this evaluation, the smaller the step, the better the flatness. Note that, in this evaluation, a trench pattern having a depth of 0.10 µm was planarized using a resist underlayer film material at a film thickness of approximately 0.2 µm. This is a severe evaluation condition to evaluate the flatness.

**[Table 5]**

| | Resist underlayer film material | Step |
|---|---|---|
| | | (nm) |
| Example 4-1 | UDL-1 | 25 |
| Example 4-2 | UDL-2 | 30 |
| Example 4-3 | UDL-3 | 35 |
| Example 4-4 | UDL-4 | 30 |
| Example 4-5 | UDL-5 | 30 |
| Example 4-6 | UDL-6 | 40 |
| Example 4-7 | UDL-7 | 25 |
| Example 4-8 | UDL-8 | 20 |
| Example 4-9 | UDL-9 | 15 |
| Example 4-10 | UDL-10 | 20 |
| Example 4-11 | UDL-11 | 15 |
| Example 4-12 | UDL-12 | 15 |
| Example 4-13 | UDL-13 | 15 |
| Example 4-14 | UDL-14 | 40 |
| Example 4-15 | UDL-15 | 20 |
| Example 4-16 | UDL-16 | 30 |
| Comparative Example 4-1 | Comparative UDL-1 | 40 |
| Comparative Example 4-2 | Comparative UDL-2 | 25 |
| Comparative Example 4-3 | Comparative UDL-3 | 80 |

As shown in Table 5, regarding the inventive resist underlayer film materials used in Examples 4-1 to 4-16, the steps in each of the resist underlayer films between the trench portion and the non-trench portion were smaller than in Comparative Example 4-3, where contained was a polymer different from the component (A) contained in the inventive resist underlayer film material, and it can be seen that the inventive materials were excellent in flatness.

Furthermore, from the above results of Examples 3 and 4, it can be seen that the inventive resist underlayer film material makes it possible to form a resist underlayer film excellent in flatness and film-formability, even on a substrate to be processed having portions that are particularly difficult to planarize.

### Example 5: Patterning Test (Examples 5-1 to 5-16, Comparative Examples 5-1 to 5-3)

Each of UDL-1 to -16 and comparative UDL-1 to -3 prepared above was respectively applied onto an SiO₂ substrate having a trench pattern (trench width: 10 µm, trench depth: 0.10 µm) and having a 200-nm thick SiO₂ film treated with HMDS at 120°C for 120 seconds formed thereon. The obtained coating film was baked in the atmosphere at 250°C for 60 seconds so as to achieve a film thickness of 200 nm on a bare Si substrate. Thus, a resist underlayer film was formed. Subsequently, a silicon-containing resist middle layer film material (SOG-1) was applied onto the resist underlayer film, and the coating film was baked at 220°C for 60 seconds to form a 35-nm thick resist middle layer film. Subsequently, a resist upper layer film material (SL resist for ArF) was applied onto the resist middle layer film, and the coating film was baked at 105°C for 60 seconds to form a 100-nm thick resist upper layer film. Subsequently, a liquid immersion top coat composition (TC-1) was applied onto the resist upper layer film, and the coating film was baked at 90°C for 60 seconds to form a 50-nm thick top coat.

The resist upper layer film material (SL resist for ArF) was prepared by dissolving a polymer (RP1), an acid generator (PAG1), and a basic compound (Amine1), each in the proportion shown in Table 6, in a solvent containing 0.1 mass% of FC-430 (manufactured by Sumitomo 3M Limited), and filtering the mixture through a 0.1-µm filter made of a fluororesin.

**[Table 6]**

| | Polymer (parts by mass) | Acid generator (parts by mass) | Basic compound (parts by mass) | Solvent (parts by mass) |
|---|---|---|---|---|
| SL resist for ArF | RP1 (100) | PAG1 (6.6) | Amine1 (0.8) | PGMEA (2500) |

The structural formulae of the polymer (RP1), the acid generator (PAG1), and the basic compound (Amine1) used are shown below.

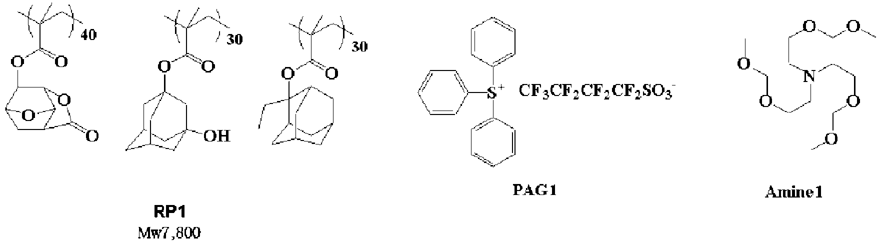

As the liquid immersion top coat composition (TC-1), used was a composition prepared by dissolving a top coat polymer (PP1) in an organic solvent in the proportion shown in Table 7, and filtering the mixture through a 0.1-µm filter made of a fluororesin.

**[Table 7]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The structural formula of the polymer (PP1) used is shown below.

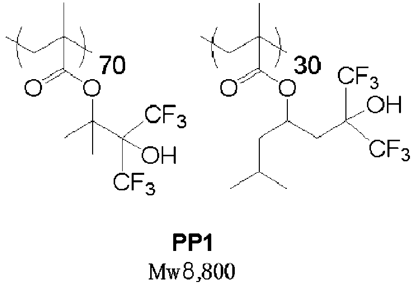

As the silicon-containing resist middle layer film material (SOG-1), used was a material prepared by dissolving a silicon-containing middle layer film polymer for ArF represented by (SiP1) and a crosslinking catalyst (CAT1) in an organic solvent containing 0.1 mass% of FC-4430 (manufactured by Sumitomo 3M Limited) in the proportions shown in Table 8, and filtering the mixture through a filter made of a fluororesin having a pore size of 0.1 µm.

**[Table 8]**

| | Polymer (parts by mass) | Thermal crosslinking catalyst (parts by mass) | Organic solvent (parts by mass) |
|---|---|---|---|
| SOG-1 | SiP1 | CAT1 | Propylene glycol monoethyl ether |
| | (100) | (1) | (4000) |

The structural formulae of the silicon-containing middle layer film polymer (SiP1) for ArF and the crosslinking catalyst (CAT1) used are shown below.

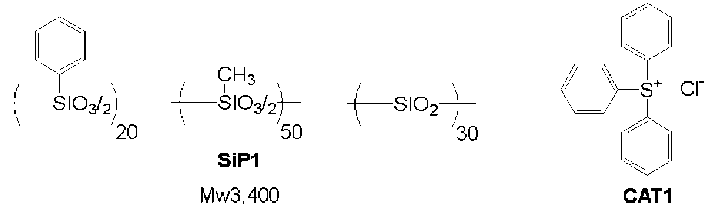

Then, the resist upper layer film was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask) while changing the exposure dose, baked at 100°C for 60 seconds (PEB), and developed with a 2.38% by mass aqueous solution of tetramethylammonium hydroxide (TMAH) for 30 seconds. Thus, positive line-and-space patterns having a pitch of 100 nm and resist line widths of 50 nm to 30 nm were obtained.

Subsequently, by dry etching using an etching apparatus Telius manufactured by Tokyo Electron Ltd., the silicon-containing resist middle layer film was processed while using the resist pattern as a mask, the resist underlayer film was processed while using the silicon-containing middle layer film as a mask, and the SiO₂ film was processed while using the underlayer film as a mask.

The etching conditions were as shown below.

Conditions in transferring resist pattern to SOG film (silicon-containing resist middle layer film).

| | |
|---|---|
| Chamber pressure: | 10.0 Pa |
| RF-power: | 1,500 W |
| CF₄ gas flow rate: | 15 sccm |
| O₂ gas flow rate: | 75 sccm |
| Time: | 15 sec |

Conditions in transferring SOG film pattern to resist underlayer film.

| | |
|---|---|
| Chamber pressure: | 2.0 Pa |
| RF-power: | 500 W |
| Ar gas flow rate: | 75 sccm |
| O₂ gas flow rate: | 45 sccm |
| Time: | 120 sec |

Conditions in transferring underlayer film pattern to SiO₂ film.

| | |
|---|---|
| Chamber pressure: | 2.0 Pa |
| RF-power: | 2,200 W |
| C₅F₁₂ gas flow rate: | 20 sccm |
| C₂F₆ gas flow rate: | 10 sccm |
| Ar gas flow rate: | 300 sccm |
| O₂ gas flow rate: | 60 sccm |
| Time: | 90 sec |

The cross section of the pattern was observed with an electron microscope (S-4700) manufactured by Hitachi, Ltd., and the profiles were compared and summarized in Table 9.

**[Table 9]**

| | Resist underlayer film material | Pattern profile after etching for transferring to substrate |
|---|---|---|
| Example 5-1 | UDL-1 | Vertical profile |
| Example 5-2 | UDL-2 | Vertical profile |
| Example 5-3 | UDL-3 | Vertical profile |
| Example 5-4 | UDL-4 | Vertical profile |
| Example 5-5 | UDL-5 | Vertical profile |
| Example 5-6 | UDL-6 | Vertical profile |
| Example 5-7 | UDL-7 | Vertical profile |
| Example 5-8 | UDL-8 | Vertical profile |
| Example 5-9 | UDL-9 | Vertical profile |
| Example 5-10 | UDL-10 | Vertical profile |
| Example 5-11 | UDL-11 | Vertical profile |
| Example 5-12 | UDL-12 | Vertical profile |
| Example 5-13 | UDL-13 | Vertical profile |
| Example 5-14 | UDL-14 | Vertical profile |
| Example 5-15 | UDL-15 | Vertical profile |
| Example 5-16 | UDL-16 | Vertical profile |
| Comparative Example 5-1 | Comparative UDL-1 | Pattern profile collapse |
| Comparative Example 5-2 | Comparative UDL-2 | Pattern profile collapse |
| Comparative Example 5-3 | Comparative UDL-3 | Pattern profile collapse |

As shown in Table 9, in Examples 5-1 to 5-16, where the inventive resist underlayer film materials were used, the resist upper layer film pattern was favorably transferred to the final substrate in each case, thus confirming that the inventive resist underlayer film materials can be suitably used in fine processing according to the multilayer resist method. On the other hand, in Comparative Examples 5-1 and 5-2, as shown by the results of the film-formability evaluation of Comparative Examples 1-1 and 1-2, pattern collapse occurred during patterning due to the pinholes that were generated during film formation, and it was not possible to form a pattern. In Comparative Example 5-3, as shown by Comparative Example 3-3 and Comparative Example 4-3, filling property and flatness were poor, so that pattern collapse occurred during patterning, and it was not possible to form a pattern.

From the above, it has been revealed that the inventive resist underlayer film material has favorable film-formability and is excellent in filling property and flatness, and therefore, is extremely useful as an organic film material used in a multilayer resist method; in addition, the inventive patterning process, using the material, makes it possible to form a fine pattern with high precision even when the body to be processed is a stepped substrate.

The present description includes the following embodiments.
[1] A resist underlayer film material, comprising:
   (A) a compound or resin represented by the following general formula (1); and
   (B) an organic solvent, 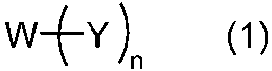
      wherein W represents an n-valent organic group having 2 to 50 carbon atoms, each Y has either a terminal group structure represented by the following general formula (2) or a terminal group structure represented by the following general formula (3), "a" and "b" satisfying relationships a+b = 1.0, 0.70 ≤ a ≤ 0.99, and 0.01 ≤ b ≤ 0.30, where the "a" and the "b" respectively represent a proportion of the terminal group structure represented by the following general formula (2) constituting the Y and a proportion of the terminal group structure represented by the following general formula (3) constituting the Y, and "n" represents an integer of 1 to 10, 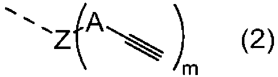
      wherein a broken line represents an attachment point, Z represents an (m+1)-valent aromatic group having 6 to 20 carbon atoms, A represents a single bond or -O-(CH₂)ₚ-, "m" represents an integer of 1 to 5, and "p" represents an integer of 1 to 10, 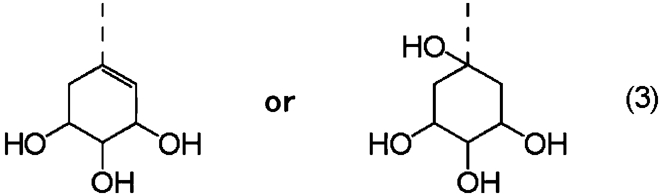
      wherein a broken line represents an attachment point.
[2] The resist underlayer film material according to [1], wherein the A in the general formula (2) represents -OCH₂-.
[3] The resist underlayer film material according to [1] or [2], wherein the general formula (2) is any of the following general formulae (4), (5), and (6), 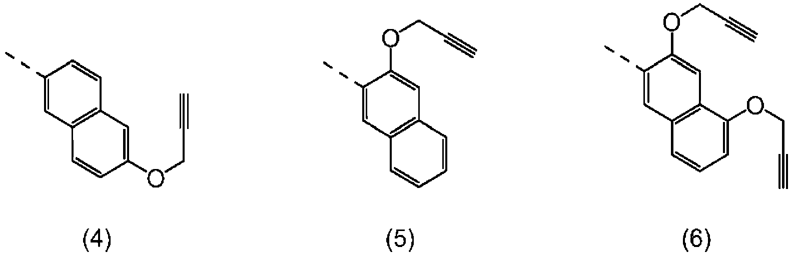 wherein a broken line represents an attachment point.
[4] The resist underlayer film material according to any one of [1] to [3], wherein the W in the general formula (1) is represented by the following general formula (7), 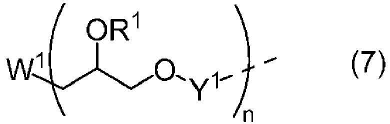 wherein a broken line represents an attachment point, R¹ represents a hydrogen atom or an alkyl group or an acyl group each having 1 to 20 carbon atoms, the alkyl group or the acyl group optionally containing an oxygen atom and/or a nitrogen atom, W¹ represents an n-valent organic group having 1 to 47 carbon atoms, Y¹ represents a single bond or a carbonyl group, and "n" represents an integer of 1 to 10.
[5] The resist underlayer film material according to [4], wherein the W¹ in the general formula (7) has a structure represented by any of the following formulae, 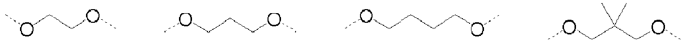 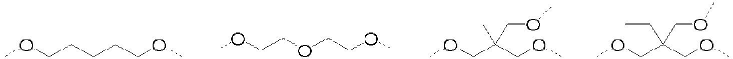 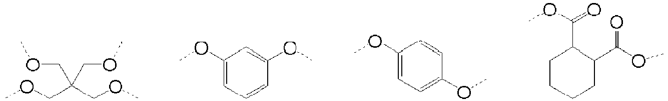 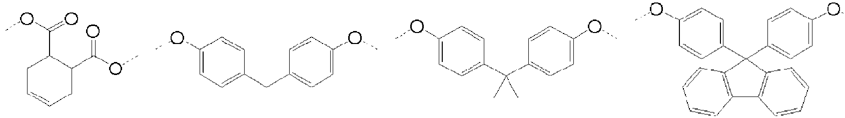 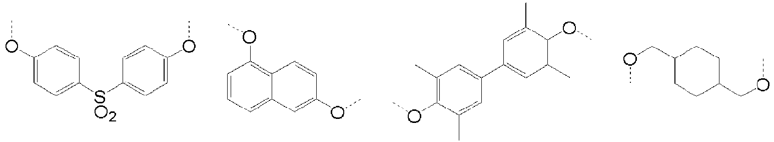 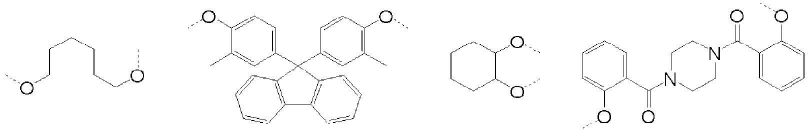 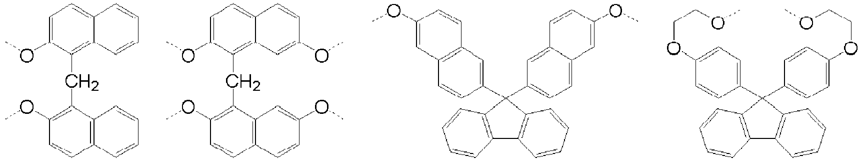 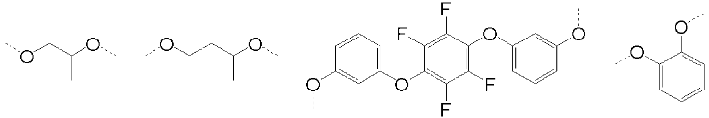 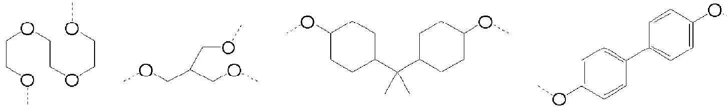 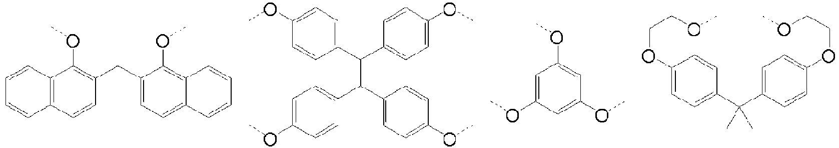 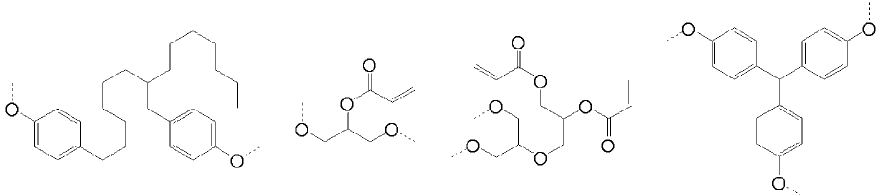 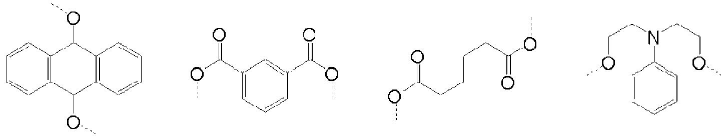 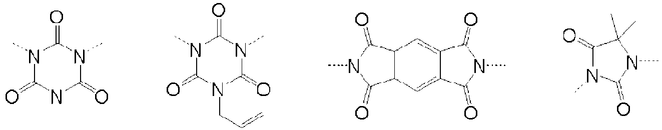 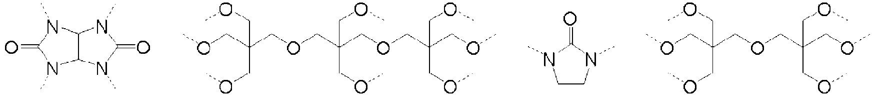 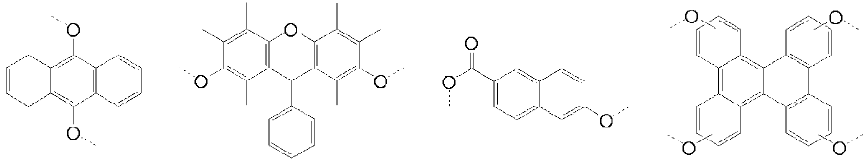 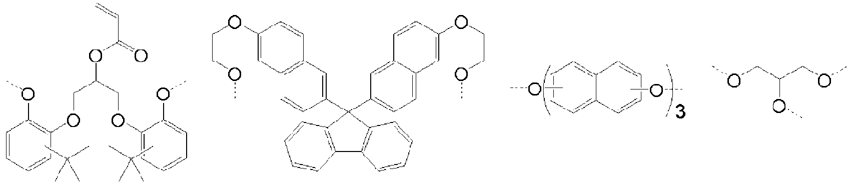 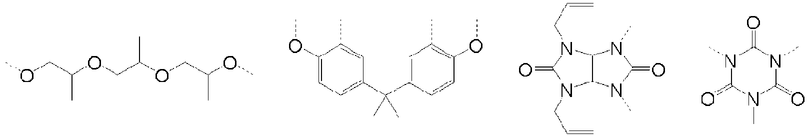 wherein a broken line represents an attachment point.
[6] The resist underlayer film material according to any one of [1] to [5], wherein the compound or resin (A) has a weight-average molecular weight of 3,000 or less in terms of polystyrene.
[7] The resist underlayer film material according to any one of [1] to [6], wherein the organic solvent (B) is a mixture of one or more kinds of organic solvent having a boiling point of lower than 180°C and one or more kinds of organic solvent having a boiling point of 180°C or higher.
[8] The resist underlayer film material according to any one of [1] to [7], further comprising one or more kinds selected from the group consisting of:
   (C) a base generator;
   (D) a surfactant;
   (E) a crosslinking agent;
   (F) a plasticizer; and
   (G) a colorant.
[9] The resist underlayer film material according to [8], wherein the base generator (C) is a compound that exhibits basicity upon pyrolysis.
[10] The resist underlayer film material according to [9], wherein the base generator (C) is a compound represented by any of the following general formulae (8), (9), and (10), 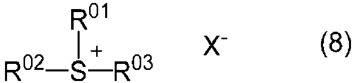 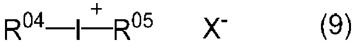 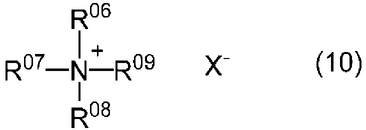 wherein R⁰¹ to R⁰³ each independently represent a linear, branched, or cyclic alkyl group or alkenyl group, each having 1 to 10 carbon atoms, optionally having a substituent which is a heteroatom and optionally having an intervening heteroatom, or represent an aryl group or aralkyl group each having 6 to 18 carbon atoms, optionally having a substituent which is a heteroatom, and optionally having an intervening heteroatom, any two of R⁰¹, R⁰², and R⁰³ optionally being bonded to each other to form a ring together with the sulfur atom in the formula, X⁻ represents an organic or inorganic anion to be a counter ion, provided that X⁻ does not include OH⁻, R⁰⁴ and R⁰⁵ each independently represent an aryl group having 6 to 20 carbon atoms, part or all of hydrogen atoms of the aryl group optionally being substituted with a linear, branched, or cyclic alkyl group or alkoxy group each having 1 to 10 carbon atoms, and R⁰⁴ and R⁰⁵ optionally being bonded to each other to form a ring together with the iodine atom in the formula, and R⁰⁶, R⁰⁷, R⁰⁸, and R⁰⁹ each independently represent a hydrogen atom, represent a linear, branched, or cyclic alkyl group or alkenyl group each having 1 to 20 carbon atoms, optionally having a substituent which is a heteroatom and optionally having an intervening heteroatom, or represent an aryl group or aralkyl group each having 6 to 18 carbon atoms, optionally having a substituent which is a heteroatom, and optionally having an intervening heteroatom, any two of R⁰⁶, R⁰⁷, R⁰⁸, and R⁰⁹ optionally being bonded to each other to form a ring together with the nitrogen atom in the formula.
[11] The resist underlayer film material according to [10], wherein the anion X⁻ in the general formulae (8), (9), and (10) is an anion selected from the group consisting of ions having structures represented by any of the following general formulae (11), (12), and (13), a chloride ion, a bromide ion, an iodide ion, a fluoride ion, a cyanide ion, a nitrate ion, and a nitrite ion,

   R¹⁰-COO⁻ (11)

   R¹¹-SO₃⁻ (12)

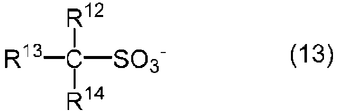

   wherein R¹⁰ represents a linear, branched, or cyclic alkyl group, an alkenyl group, an aralkyl group, or an aryl group, each having 1 to 20 carbon atoms and optionally containing an ether group, an ester group, or a carbonyl group, one or more hydrogen atoms of the groups optionally being substituted with a halogen atom, a hydroxy group, a carboxy group, an amino group, and/or a cyano group, R¹¹ represents an aryl group having 6 to 20 carbon atoms, one or more hydrogen atoms of the aryl group optionally being substituted with a halogen atom, a hydroxy group, a carboxy group, an amino group, and/or a cyano group, and R¹², R¹³, and R¹⁴ each independently represent a hydrogen atom, a halogen atom other than a fluorine atom, or a linear, branched, or cyclic alkyl group, an alkenyl group, an aralkyl group, or an aryl group, each having 1 to 20 carbon atoms and optionally containing an ether group, an ester group, or a carbonyl group, one or more hydrogen atoms of the groups optionally being substituted with a halogen atom, a hydroxy group, a carboxy group, an amino group, and/or a cyano group, and two or more of R¹², R¹³, and R¹⁴ optionally being bonded to each other to form a ring.
[12] The resist underlayer film material according to [10] or [11], wherein a conjugate acid X-H of the X⁻ in the general formulae (8), (9), and (10) has a boiling point of 200°C or lower.
[13] The resist underlayer film material according to any one of [8] to [12], wherein the crosslinking agent (E) is a compound represented by the following general formula (14), 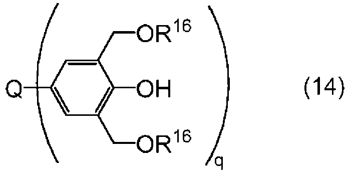 wherein Q represents a single bond or a q-valent hydrocarbon group having 1 to 20 carbon atoms, R¹⁶ represents a hydrogen atom or an alkyl group having 1 to 20 carbon atoms, and "q" represents an integer of 1 to 5.
[14] A patterning process for forming a pattern in a substrate to be processed, comprising the steps of:
   (I-1) applying the resist underlayer film material according to any one of [1] to [13] onto a substrate to be processed to obtain a coating film and then heating the coating film to form a resist underlayer film;
   (I-2) forming a resist upper layer film on the resist underlayer film by using a photoresist material;
   (I-3) subjecting the resist upper layer film to pattern exposure and then development with a developer to form a pattern in the resist upper layer film;
   (I-4) transferring the pattern to the resist underlayer film by dry-etching the resist underlayer film while using the resist upper layer film having the formed pattern as a mask; and
   (I-5) forming the pattern in the substrate to be processed by processing the substrate to be processed while using the resist underlayer film having the formed pattern as a mask.
[15] A patterning process for forming a pattern in a substrate to be processed, comprising the steps of:
   (II-1) applying the resist underlayer film material according to any one of [1] to [13] onto a substrate to be processed to obtain a coating film and then heating the coating film to form a resist underlayer film;
   (II-2) forming a resist middle layer film on the resist underlayer film;
   (II-3) forming a resist upper layer film on the resist middle layer film by using a photoresist material;
   (II-4) subjecting the resist upper layer film to pattern exposure and then development with a developer to form a pattern in the resist upper layer film;
   (II-5) transferring the pattern to the resist middle layer film by dry-etching the resist middle layer film while using the resist upper layer film having the formed pattern as a mask;
   (II-6) transferring the pattern to the resist underlayer film by dry-etching the resist underlayer film while using the resist middle layer film having the transferred pattern as a mask; and
   (II-7) forming the pattern in the substrate to be processed by processing the substrate to be processed while using the resist underlayer film having the formed pattern as a mask.
[16] A patterning process for forming a pattern in a substrate to be processed, comprising the steps of:
   (III-1) applying the resist underlayer film material according to any one of [1] to [13] onto a substrate to be processed to obtain a coating film and then heating the coating film to form a resist underlayer film;
   (III-2) forming an inorganic hard mask middle layer film selected from the group consisting of a silicon oxide film, a silicon nitride film, and a silicon oxynitride film on the resist underlayer film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry-etching the organic thin film and the inorganic hard mask middle layer film while using the resist upper layer film having the formed pattern as a mask;
   (III-7) transferring the pattern to the resist underlayer film by dry-etching the resist underlayer film while using the inorganic hard mask middle layer film having the transferred pattern as a mask; and
   (III-8) forming the pattern in the substrate to be processed by processing the substrate to be processed while using the resist underlayer film having the formed pattern as a mask.
[17] The patterning process according to [16], wherein the inorganic hard mask middle layer film is formed by a CVD method or an ALD method.
[18] The patterning process according to any one of [14] to [17], wherein a substrate having a structure or step having a height of 30 nm or more is used as the substrate to be processed.
[19] The patterning process according to any one of [14] to [17], wherein a substrate having a static contact angle of 50° or more with water is used as the substrate to be processed.
[20] A method for forming a resist underlayer film that functions as an organic flat film employed in a semiconductor device manufacturing process, the method comprising:
   spin-coating a substrate to be processed with the resist underlayer film material according to any one of [1] to [13]; and
   heating the substrate coated with the resist underlayer film material at a temperature of 100°C or higher to 600°C or lower for 10 to 600 seconds to cure the material and form a resist underlayer film.
[21] A method for forming a resist underlayer film that functions as an organic flat film employed in a semiconductor device manufacturing process, the method comprising:
   spin-coating a substrate to be processed with the resist underlayer film material according to any one of [1] to [13]; and
   heating the substrate coated with the resist underlayer film material in an atmosphere having an oxygen concentration of 1 volume% or more to 21 volume% or less to cure the material and form a resist underlayer film.
[22] A method for forming a resist underlayer film that functions as an organic flat film employed in a semiconductor device manufacturing process, the method comprising:
   spin-coating a substrate to be processed with the resist underlayer film material according to any one of [1] to [13]; and
   heating the substrate coated with the resist underlayer film material in an atmosphere having an oxygen concentration of less than 1 volume% to cure the material and form a resist underlayer film.
[23] The method for forming a resist underlayer film according to any one of [20] to [22], wherein a substrate having a structure or step having a height of 30 nm or more is used as the substrate to be processed.
[24] The method for forming a resist underlayer film according to any one of [20] to [23], wherein a substrate having a static contact angle of 50° or more with water is used as the substrate to be processed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A resist underlayer film material, comprising:
(A) a compound or resin represented by the following general formula (1); and
(B) an organic solvent, 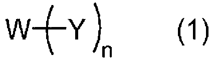
wherein W represents an n-valent organic group having 2 to 50 carbon atoms, each Y has either a terminal group structure represented by the following general formula (2) or a terminal group structure represented by the following general formula (3), "a" and "b" satisfying relationships a+b = 1.0, 0.70 ≤ a ≤ 0.99, and 0.01 ≤ b ≤ 0.30, where the "a" and the "b" respectively represent a proportion of the terminal group structure represented by the following general formula (2) constituting the Y and a proportion of the terminal group structure represented by the following general formula (3) constituting the Y, and "n" represents an integer of 1 to 10, 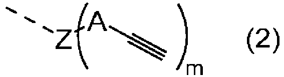
wherein a broken line represents an attachment point, Z represents an (m+1)-valent aromatic group having 6 to 20 carbon atoms, A represents a single bond or -O-(CH₂)ₚ-, "m" represents an integer of 1 to 5, and "p" represents an integer of 1 to 10, 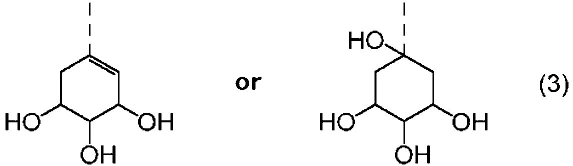
wherein a broken line represents an attachment

2. The resist underlayer film material according to claim 1, wherein the A in the general formula (2) represents -OCH₂-.

3. The resist underlayer film material according to claim 1 or 2, wherein the general formula (2) is any of the following general formulae (4), (5), and (6), 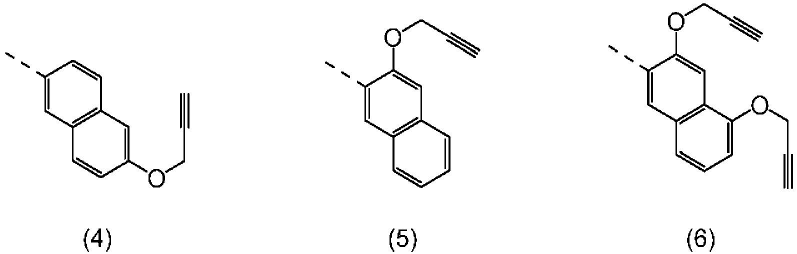 wherein a broken line represents an attachment point.

4. The resist underlayer film material according to any one of claims 1 to 3, wherein the W in the general formula (1) is represented by the following general formula (7), 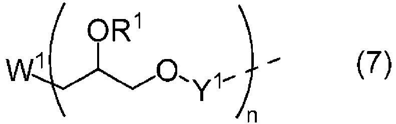
wherein a broken line represents an attachment point, R¹ represents a hydrogen atom or an alkyl group or an acyl group each having 1 to 20 carbon atoms, the alkyl group or the acyl group optionally containing an oxygen atom and/or a nitrogen atom, W¹ represents an n-valent organic group having 1 to 47 carbon atoms, Y¹ represents a single bond or a carbonyl group, and "n" represents an integer of 1 to 10,
preferably wherein the W¹ in the general formula (7) has a structure represented by any of the following formulae, 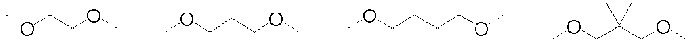 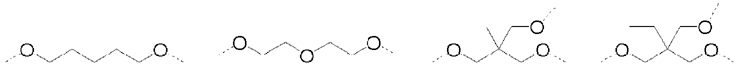 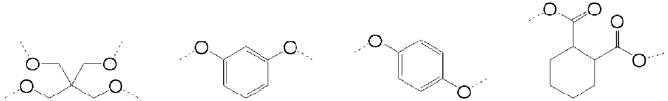 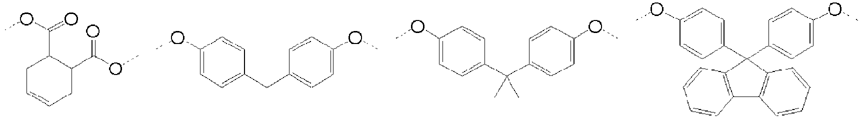 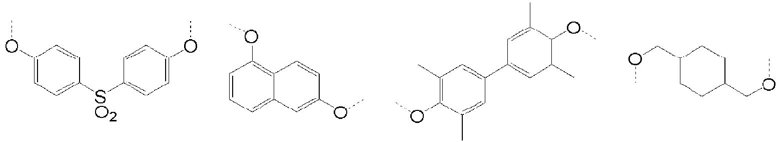 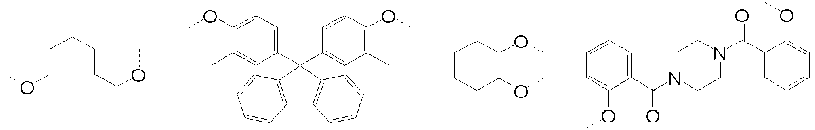 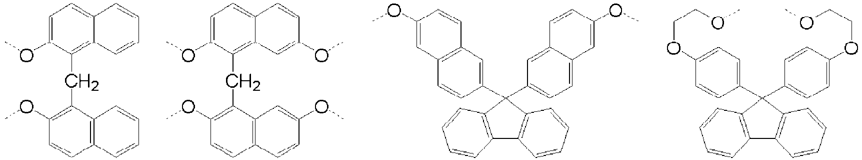 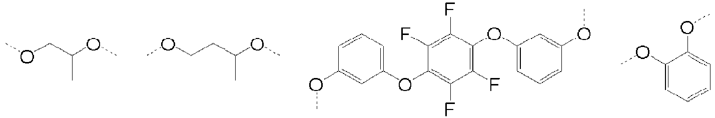 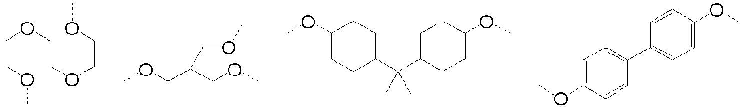 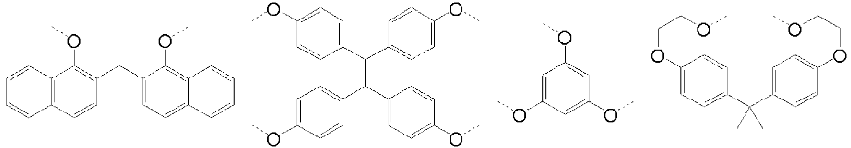 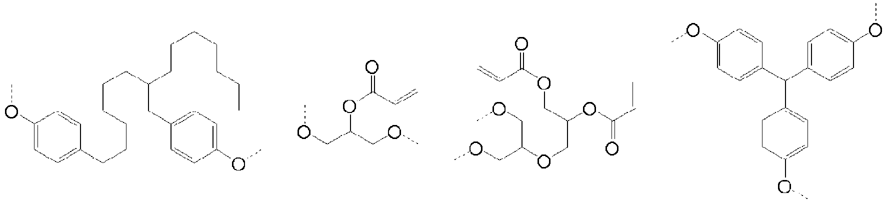 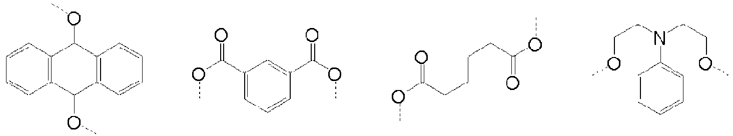 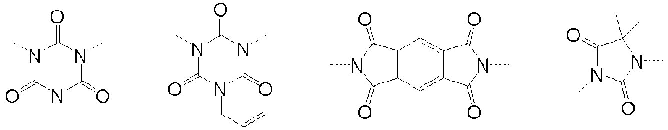 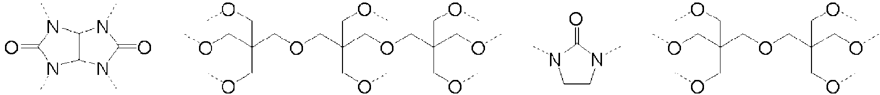 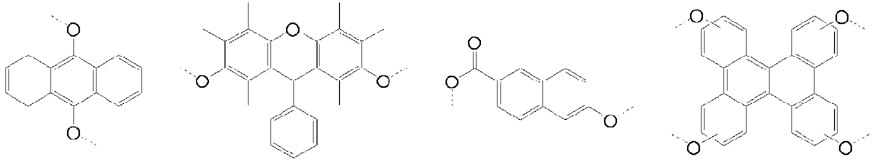 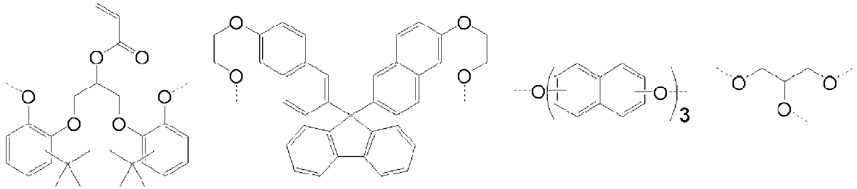 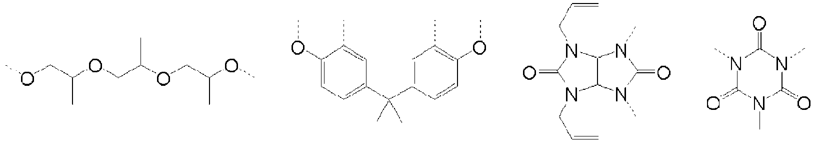
wherein a broken line represents an attachment point.

5. The resist underlayer film material according to any one of claims 1 to 4, wherein the compound or resin (A) has a weight-average molecular weight of 3,000 or less in terms of polystyrene.

6. The resist underlayer film material according to any one of claims 1 to 5, wherein the organic solvent (B) is a mixture of one or more kinds of organic solvent having a boiling point of lower than 180°C and one or more kinds of organic solvent having a boiling point of 180°C or higher.

7. The resist underlayer film material according to any one of claims 1 to 6, further comprising one or more kinds selected from the group consisting of:
(C) a base generator;
(D) a surfactant;
(E) a crosslinking agent;
(F) a plasticizer; and
(G) a colorant.

8. The resist underlayer film material according to claim 7, wherein the base generator (C) is a compound that exhibits basicity upon pyrolysis,
preferably wherein the base generator (C) is a compound represented by any of the following general formulae (8), (9), and (10), 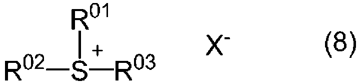 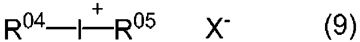 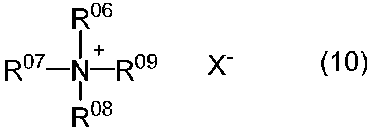
wherein R⁰¹ to R⁰³ each independently represent a linear, branched, or cyclic alkyl group or alkenyl group, each having 1 to 10 carbon atoms, optionally having a substituent which is a heteroatom and optionally having an intervening heteroatom, or represent an aryl group or aralkyl group each having 6 to 18 carbon atoms, optionally having a substituent which is a heteroatom, and optionally having an intervening heteroatom, any two of R⁰¹, R⁰², and R⁰³ optionally being bonded to each other to form a ring together with the sulfur atom in the formula, X⁻ represents an organic or inorganic anion to be a counter ion, provided that X⁻ does not include OH⁻, R⁰⁴ and R⁰⁵ each independently represent an aryl group having 6 to 20 carbon atoms, part or all of hydrogen atoms of the aryl group optionally being substituted with a linear, branched, or cyclic alkyl group or alkoxy group each having 1 to 10 carbon atoms, and R⁰⁴ and R⁰⁵ optionally being bonded to each other to form a ring together with the iodine atom in the formula, and R⁰⁶, R⁰⁷, R⁰⁸, and R⁰⁹ each independently represent a hydrogen atom, represent a linear, branched, or cyclic alkyl group or alkenyl group each having 1 to 20 carbon atoms and optionally having a substituent which is a heteroatom and optionally having an intervening heteroatom, or represent an aryl group or aralkyl group each having 6 to 18 carbon atoms, optionally having a substituent which is a heteroatom, and optionally having an intervening heteroatom, any two of R⁰⁶, R⁰⁷, R⁰⁸, and R⁰⁹ optionally being bonded to each other to form a ring together with the nitrogen atom in the formula,
more preferably wherein the anion X⁻ in the general formulae (8), (9), and (10) is an anion selected from the group consisting of ions having structures represented by any of the following general formulae (11), (12), and (13), a chloride ion, a bromide ion, an iodide ion, a fluoride ion, a cyanide ion, a nitrate ion, and a nitrite ion,
R¹⁰-COO⁻ (11)
R¹¹-SO₃⁻ (12) 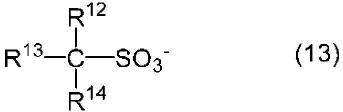
wherein R¹⁰ represents a linear, branched, or cyclic alkyl group, an alkenyl group, an aralkyl group, or an aryl group, each having 1 to 20 carbon atoms and optionally containing an ether group, an ester group, or a carbonyl group, one or more hydrogen atoms of the groups optionally being substituted with a halogen atom, a hydroxy group, a carboxy group, an amino group, and/or a cyano group, R¹¹ represents an aryl group having 6 to 20 carbon atoms, one or more hydrogen atoms of the aryl group optionally being substituted with a halogen atom, a hydroxy group, a carboxy group, an amino group, and/or a cyano group, and R¹², R¹³, and R¹⁴ each independently represent a hydrogen atom, a halogen atom other than a fluorine atom, or a linear, branched, or cyclic alkyl group, an alkenyl group, an aralkyl group, or an aryl group, each having 1 to 20 carbon atoms and optionally containing an ether group, an ester group, or a carbonyl group, one or more hydrogen atoms of the groups optionally being substituted with a halogen atom, a hydroxy group, a carboxy group, an amino group, and/or a cyano group, and two or more of R¹², R¹³, and R¹⁴ optionally being bonded to each other to form a ring.

9. The resist underlayer film material according to claim 8, wherein a conjugate acid X-H of the X⁻ in the general formulae (8), (9), and (10) has a boiling point of 200°C or lower.

10. The resist underlayer film material according to any one of claims 7 to 9, wherein the crosslinking agent (E) is a compound represented by the following general formula (14), 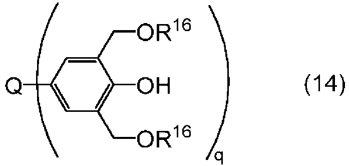 wherein Q represents a single bond or a q-valent hydrocarbon group having 1 to 20 carbon atoms, R¹⁶ represents a hydrogen atom or an alkyl group having 1 to 20 carbon atoms, and "q" represents an integer of 1 to 5.

11. A patterning process for forming a pattern in a substrate to be processed, comprising the steps of:
(I-1) applying the resist underlayer film material according to any one of claims 1 to 10 onto a substrate to be processed to obtain a coating film and then heating the coating film to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(I-4) transferring the pattern to the resist underlayer film by dry-etching the resist underlayer film while using the resist upper layer film having the formed pattern as a mask; and
(I-5) forming the pattern in the substrate to be processed by processing the substrate to be processed while using the resist underlayer film having the formed pattern as a mask, or
a patterning process for forming a pattern in a substrate to be processed, comprising the steps of:
(II-1) applying the resist underlayer film material according to any one of claims 1 to 10 onto a substrate to be processed to obtain a coating film and then heating the coating film to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry-etching the resist middle layer film while using the resist upper layer film having the formed pattern as a mask;
(II-6) transferring the pattern to the resist underlayer film by dry-etching the resist underlayer film while using the resist middle layer film having the transferred pattern as a mask; and
(II-7) forming the pattern in the substrate to be processed by processing the substrate to be processed while using the resist underlayer film having the formed pattern as a mask, or
a patterning process for forming a pattern in a substrate to be processed, comprising the steps of:
(III-1) applying the resist underlayer film material according to any one of claims 1 to 10 onto a substrate to be processed to obtain a coating film and then heating the coating film to form a resist underlayer film;
(III-2) forming an inorganic hard mask middle layer film selected from the group consisting of a silicon oxide film, a silicon nitride film, and a silicon oxynitride film on the resist underlayer film, preferably wherein the inorganic hard mask middle layer film is formed by a CVD method or an ALD method;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry-etching the organic thin film and the inorganic hard mask middle layer film while using the resist upper layer film having the formed pattern as a mask;
(III-7) transferring the pattern to the resist underlayer film by dry-etching the resist underlayer film while using the inorganic hard mask middle layer film having the transferred pattern as a mask; and
(III-8) forming the pattern in the substrate to be processed by processing the substrate to be processed while using the resist underlayer film having the formed pattern as a mask.

12. The patterning process according to claim 11, wherein a substrate having a structure or step having a height of 30 nm or more is used as the substrate to be processed.

13. The patterning process according to claim 11 or 12, wherein a substrate having a static contact angle of 50° or more with water is used as the substrate to be processed.

14. A method for forming a resist underlayer film that functions as an organic flat film employed in a semiconductor device manufacturing process, the method comprising:
spin-coating a substrate to be processed with the resist underlayer film material according to any one of claims 1 to 10; and
heating the substrate coated with the resist underlayer film material at a temperature of 100°C or higher to 600°C or lower for 10 to 600 seconds to cure the material and form a resist underlayer film, or
a method for forming a resist underlayer film that functions as an organic flat film employed in a semiconductor device manufacturing process, the method comprising:
spin-coating a substrate to be processed with the resist underlayer film material according to any one of claims 1 to 10; and
heating the substrate coated with the resist underlayer film material in an atmosphere having an oxygen concentration of 1 volume% or more to 21 volume% or less to cure the material and form a resist underlayer film, or
a method for forming a resist underlayer film that functions as an organic flat film employed in a semiconductor device manufacturing process, the method comprising:
spin-coating a substrate to be processed with the resist underlayer film material according to any one of claims 1 to 10; and
heating the substrate coated with the resist underlayer film material in an atmosphere having an oxygen concentration of less than 1 volume% to cure the material and form a resist underlayer film,
preferably wherein a substrate having a structure or step having a height of 30 nm or more is used as the substrate to be processed.

15. The method for forming a resist underlayer film according to claim 14, wherein a substrate having a static contact angle of 50° or more with water is used as the substrate to be processed.
